# EUROPÄISCHE PATENTSCHRIFT

(11) **EP 2 388 609 B1**
(45) Veröffentlichungstag und Bekanntmachung des Hinweises auf die Patenterteilung: **08.01.2020**
(21) Anmeldenummer: 11166361.3
(22) Anmeldetag: 17.05.2011
(51) Int. Cl.: G01R 33/31

(54) **Temperiereinrichtung für ein NMR-Probenröhrchen**
Tempering device for an NMR sample tube
Dispositif de thermorégulation pour des tubes à essai RMN

(30) Priorität: 18.05.2010 DE 102010029080
(43) Veröffentlichungstag der Anmeldung: 23.11.2011
(73) Patentinhaber: Bruker Switzerland AG, 8117 Fällanden (CH)
(72) Erfinder: Grossniklaus, Beat, 8173 Neerach (CH); Raffa, Federico, 8049 Zürich (CH); Mayer, Markus, 8625 Gossau (CH); Wilhelm, Dirk, 8124 Maur (CH)
(74) Vertreter: Kohler Schmid Möbus Patentanwälte

(56) Entgegenhaltungen:
- DE-A1- 4 018 734
- JP-U- 52 117 985
- JP-U- 58 099 655
- US-A1- 2007 007 963
- LOENING N M ET AL: "TEMPERATURE ACCURACY AND TEMPERATURE GRADIENTS IN SOLUTION-STATE NMR SPECTROMETERS", JOURNAL OF MAGNETIC RESONANCE, ACADEMIC PRESS, ORLANDO, FL, US, Bd. 159, Nr. 1, 1. November 2002 (2002-11-01), Seiten 55-61, XP001144374, ISSN: 1090-7807, DOI: 10.1016/S1090-7807(02)00120-9

## Beschreibung

Die Erfindung betrifft eine Temperiereinrichtung für ein NMR-Probenröhrchen, wobei um einen zylindrischen Innenraum zur Aufnahme des NMR-Probenröhrchens mehrere ineinander geschachtelte, konzentrische, zum Innenraum koaxial verlaufende Strömungskanäle für temperierendes Fluid ausgebildet sind,
wobei die Temperiereinrichtung in einem axialen Endbereich geschlossen zum Innenraum und in einem gegenüberliegenden axialen Endbereich für das Einführen des NMR-Probenröhrchens in den Innenraum offen zum Innenraum ausgebildet ist,
wobei in einem Gegenstrombereich benachbarte Strömungskanäle jeweils mit einem Fluiddurchlass an einem axialen Ende so miteinander verbunden sind, dass sich die Strömungsrichtung eines Fluidstroms in den Strömungskanälen des Gegenstrombereichs zum jeweils benachbarten Strömungskanal im Gegenstrombereich umkehrt,
wobei der äußerste Strömungskanal des Gegenstrombereichs an einem axialen Ende einen Fluideinlass aufweist,
und wobei der innerste Strömungskanal des Gegenstrombereichs an einem axialen Ende, welches dem geschlossen ausgebildeten axialen Endbereich zugewandt ist, einen Fluiddurchlass zum Innenraum aufweist, und wobei die Temperiereinrichtung weiterhin das NMR-Probenröhrchen umfasst, das im Innenraum angeordnet ist.

Eine solche Temperiereinrichtung ist aus der DE 40 18 734 C2 bekannt geworden.

Ein leistungsfähiges Verfahren der instrumentellen Analytik stellt die Kernspinresonanz(=NMR)-Spektroskopie dar. Bei der NMR-Spektroskopie werden in eine Messprobe, die in einem starken, statischen Magnetfeld angeordnet ist, Hochfrequenz(=HF)-Pulse eingestrahlt, und die HF-Reaktion der Messprobe wird vermessen. Dabei werden die Informationen integral über einen gewissen Bereich der Messprobe, das so genannte aktive Volumen, gewonnen.

Die Temperatur der Messprobe beeinflusst grundsätzlich das Ergebnis einer NMR-spektroskopischen Messung. Für qualitativ hochwertige Messergebnisse wird die Messprobe während der NMR-Messung auf einer möglichst konstanten und über das aktive Volumen möglichst einheitlichen Temperatur gehalten. Im Probenkopf eines NMR-Spektrometers befindet sich dafür typischerweise eine Temperiereinrichtung. Es ist sowohl verbreitet, für die NMR-Messung Messproben zu beheizen als auch Messproben zu kühlen.

Die Messprobe (also die Substanz, aus der analytische Informationen gewonnen werden sollen) ist bei einem verbreiteten Messverfahren in einem so genannten NMR-Probenröhrchen angeordnet. Typische NMR-Probenröhrchen haben einen Außendurchmesser von 5 mm und eine Länge von ca. 18 cm, wobei das aktive Volumen sich über ca. 25 mm der Länge erstreckt. Im NMR-Spektrometer wird das NMR-Probenröhrchen an einem (meist oberen) Ende gehalten und das andere, freie (meist untere) Ende ist von HF-Spulen umgeben und ragt in die Temperiereinrichtung; oftmals sind die HF-Spulen in die Temperiereinrichtung integriert.

Bei üblichen Temperiereinrichtungen umspült ein temperiertes Fluid (meist ein Gas wie Luft oder Stickstoff, in manchen Fällen auch eine Flüssigkeit) das Probenröhrchen zumindest im Bereich des aktiven Volumens. Im einfachsten Fall bildet die Temperiereinrichtung eine Kammer aus, in welche das Probenröhrchen mit dem freien Ende durch eine Öffnung hineinragt; ein Fluidstrom wird dann in die Kammer eingeleitet und auf das freie Ende gerichtet. Das Fluid tritt im Bereich der (im Randbereich vom Probenröhrchen nicht vollständig versperrten) Öffnung aus. Solche einfachen Temperiereinrichtungen weisen jedoch relativ hohe Temperaturgradienten im Fluidstrom bzw. über die Länge des aktiven Volumens des NMR-Probenröhrchens auf, da der Fluidstrom während des Passierens der Kammer seine Temperatur der Umgebung annähert (also beispielsweise abkühlt im Falle eines heizenden temperierenden Fluidstroms). Ein Wärmefluss findet insbesondere über die Außenwand der Temperiereinrichtung, in der das Fluid strömt, und auch über das NMR-Probenröhrchen selbst in Richtung der Röhrchenhalterung (Fixation) statt.

Um den Temperaturgradienten im das NMR-Probenröhrchen umgebenden Fluidstrom zu verringern, ist es bekannt, Temperiereinrichtungen nach dem Gegenstromprinzip auszubilden, vgl. die DE 40 18 734 C2, dortige Figur 2. In der DE 40 18 734 C2 wird ein Fluidstrom zunächst in einem äußeren, ringförmigen Strömungskanal in einer ersten axialen Richtung parallel zum Probenröhrchen geführt, dann umgelenkt und in der entgegengesetzten axialen Richtung in einem inneren Strömungskanal zurück geführt, und dann erneut umgelenkt und direkt am Probenröhrchen entlang und zu der Öffnung, durch die das NMR-Probenröhrchen in den Innenraum der Temperiereinrichtung ragt, hinaus geführt. Die Wände zwischen den Strömungskanälen und zum Innenraum fungieren als Wärmetauscher, so dass der Temperaturgradient im Fluidstrom direkt am Probenröhrchen merklich verringert ist.

Nachteilig an diesem Stand der Technik ist jedoch die relativ geringe Temperierleistung, die durch den Fluidstrom erreicht werden kann. Die mehrfachen Umlenkungen sowie das enge Führen des Fluidstroms direkt am Probenröhrchen erzeugen einen großen Strömungswiderstand, so dass der Fluidstrom begrenzt ist. Auch besteht die Gefahr, dass bei hohem Fluiddruck das NMR-Probenröhrchen aus der Temperiereinrichtung herausgedrückt und beschädigt wird.

Die US 2007/0007963 A1, dortige Fig. 1, beschreibt eine Temperiereinrichtung für ein NMR-Probenröhrchen, bei der ein Teil eines von unten am NMR-Probenröhrchen eingeblasenen Fluidstroms durch eine Ummantelung seitlich am NMR-Probenröhrchen vorbei geführt wird, und anderer Teil des Fluidstroms mit Durchflussöffnungen mittig in einen Ringkanal ausgeleitet wird. Dieser andere Teil wird teils nach oben und teils nach unten parallel zum NMR-Probenröhrchen weitergeführt und entweicht schließlich durch poröse thermische Anker.

### Aufgabe der Erfindung

Der Erfindung liegt die Aufgabe zugrunde, eine Temperierung eines NMR-Probenröhrchens mit geringem Temperaturgradienten zu gewährleisten, wobei gleichzeitig eine hohe Temperierleistung eingerichtet werden kann.

### Kurze Beschreibung der Erfindung

Diese Aufgabe wird gelöst durch eine Temperiereinrichtung der eingangs genannten Art, die dadurch gekennzeichnet ist, dass mindestens einer der Strömungskanäle, insbesondere der äußerste Strömungskanal der Temperiereinrichtung und/oder der nächst innere Strömungskanal der Temperiereinrichtung, an einem axialen Ende einen Fluidauslass aufweist, durch welchen zumindest ein Teil eines im äußersten Strömungskanal der Temperiereinrichtung geführten temperierenden Fluidstroms aus der Temperiereinrichtung entweichen kann, ohne alle Strömungskanäle des Gegenstrombereichs vollständig zu passieren, wobei die Temperiereinrichtung so ausgebildet ist, dass von einem gesamten, der Temperiereinrichtung zufliessenden temperierenden Fluidstrom wenigstens 50% durch den Fluidauslass am axialen Ende des aussersten Strömungskanals oder des nächst inneren Strömungskanals entweichen kann.

Die erfindungsgemäße Temperiereinrichtung arbeitet nach dem Gegenstromprinzip, wobei ein zusätzlicher Mantelstrom eigerichtet ist. Der zusätzliche Mantelstrom fließt entweder in einem eigenen Strömungskanal (zusätzlicher Strömungskanal; dieser liegt dann um die Strömungskanäle des Gegenstrombereichs herum), oder er fließt im äußersten Strömungskanal des Gegenstrombereichs (zusammen mit dem Gegenstrom, wobei später eine Auftrennung erfolgt). Der Gegenstrombereich wird gebildet durch seriell miteinander verbundene Strömungskanäle, zwischen denen die axiale Strömungsrichtung zum jeweils benachbarten Strömungskanal wechselt.

Der durch den erfindungsgemäßen Fluidauslass entweichende Fluidstrom oder Fluidstromteil aus dem äußersten Strömungskanal der Temperiereinrichtung (Mantelstrom) fließt nicht durch die Strömungskanäle des Gegenstrombereichs bzw. die übrigen, weiter innen liegenden Strömungskanäle des Gegenstrombereichs, und auch nicht an der Außenseite des NMR-Probenröhrchens vorbei.

Im äußersten Strömungskanal kann dann ein sehr großer Fluidstrom eingerichtet werden, auch wenn der Fluidstrom in den weiter innen liegenden Strömungskanälen und/oder unmittelbar am NMR-Probenröhrchen entlang einem hohen Strömungswiderstand ausgesetzt ist, etwa aufgrund von Umlenkungen oder geringem Strömungsquerschnitt.

Durch den Mantelstromanteil kann die Gesamttemperierleistung (Kühlung oder Beheizung) erhöht werden. Durch den Gegenstromanteil kann gleichzeitig der Temperaturgradient des Fluidstroms am NMR-Probenröhrchen gering gehalten werden. Falls eine sehr hohe Temperierleistung benötigt wird, kann diese über einen hohen Mantelstrom zur Verfügung gestellt werden. Der Gegenstrom kann gering gehalten werden, so dass im Bereich des Probenröhrchens kein ungünstig hoher Druck entsteht, oder gar das Probenröhrchen aus der Temperiereinrichtung herausgedrückt wird. Sofern ein gemeinsamer Zulauf für den Mantelstrom und den Gegenstrom eingerichtet ist, kann ein versehentlich zu hoher temperierender Gesamtfluidstrom über den erfindungsgemäßen Fluidauslass (bzw. den Mantelstromanteil) entlastet werden.

Typischerweise sind die axialen Wände, welche die Strömungskanäle voneinander trennen, und die Wand, die den Innenraum begrenzt, in transversaler Richtung gut wärmeleitend (d.h. sie wirken als Wärmetauscher), um Temperaturgradienten gering zu halten. Die Strömungskanäle erstrecken sich in axialer Richtung und haben einen (typischerweise gleichbleibenden) ringförmigen Querschnitt. Als temperierendes Fluid wird bevorzugt ein Gas, etwa Luft oder Stickstoff, eingesetzt. Erfindungsgemäss entweichen wenigstens 50% des gesamten, der Temperiereinrichtung zufließenden temperierenden Fluidstroms durch den erfindungsgemäßen Fluidauslass am axialen Ende des äußersten oder nächst inneren Strömungskanals der Temperiereinrichtung. Der gesamte, der Temperiereinrichtung zufließende temperierende Fluidstrom beträgt in der Regel zwischen 500 l/h und 1200 l/h.

### Bevorzugte Ausführungsformen der Erfindung

Bei einer besonders bevorzugten Ausführungsform der erfindungsgemäßen Temperiereinrichtung ist vorgesehen, dass der äußerste Strömungskanal des Gegenstrombereichs und/oder der nächst innere Strömungskanal des Gegenstrombereichs an dem axialen Ende, welches dem Fluideinlass abgewandt ist, den Fluidauslass aufweist, insbesondere wobei alle Strömungskanäle der Temperiereinrichtung zum Gegenstrombereich gehören. In dieser Ausführungsform kann der äußerste Strömungskanal des Gegenstrombereichs zusätzlich für den Mantelstrom genutzt werden. Ein eigener (zusätzlicher) Strömungskanal für den Mantelstrom ist nicht notwendig. Der erfindungsgemäße Fluidauslass am Ende des äußersten Strömungskanals des Gegenstrombereichs oder am Anfang des nächst inneren Strömungskanals des Gegenstrombereichs sorgt dafür, dass ein Fluidstrom aus dem äußersten Strömungskanal des Gegenstrombereichs zwischen dem Fluidauslass und dem nächst inneren Strömungskanal aufgeteilt wird. Am Fluideinlass kann dann der gesamte temperierende Fluidstrom (umfassend den Mantelstromanteil und den Gegenstromanteil) eingespeist werden. Erfindungsgemäss sind der Fluidauslass und der Fluiddurchlass zwischen dem äußersten und dem nächst inneren Strömungskanal des Gegenstrombereichs so ausgebildet, dass wenigstens 50% des gesamten Fluidstroms zum Fluidauslass herausströmt.

Bei einer vorteilhaften Weiterbildung dieser Ausführungsform ist vorgesehen, dass der äußerste Strömungskanal des Gegenstrombereichs eine äußere Abteilung und eine innere Abteilung umfasst, die von einer axialen Zwischenwand getrennt sind, wobei die axiale Zwischenwand sich über einen Teil der axialen Länge des äußersten Strömungskanals des Gegenstrombereichs erstreckt, wobei dieser Teil der axialen Länge sich von einem axialen Ende des äußersten Strömungskanals des Gegenstrombereichs, welches den Fluidauslass aufweist, weg erstreckt, und dass die äußere Abteilung den Fluidauslass aufweist, und die innere Abteilung den Fluiddurchlass zum nächst inneren Strömungskanal aufweist. Durch die Zwischenwand kann die Aufteilung des Mantelstromanteils und des Gegenstromanteils räumlich vom Fluidauslass weg verlagert werden, und insbesondere können die Aufteilung der beiden Anteile und die Umlenkung des Gegenstromanteils räumlich getrennt werden. Dadurch kann ein besseres (turbulenzenärmeres) Strömungsverhalten des Fluids erreicht werden. Die Abteilungen sind jeweils im Querschnitt ringförmig, ineinander geschachtelt, konzentrisch und erstrecken sich in axialer Richtung. Der Fluideinlass bespeist in dieser Ausführungsform beide Abteilungen, so dass in beiden Abteilungen das Fluid in die gleiche Richtung strömt; der Fluideinlass mündet hierzu in den ununterteilten (meist unteren) Abschnitt des äußersten Strömungskanals des Gegenstrombereichs. Alternativ zu dieser Ausführungsform ist es auch möglich, dass der äußerste Strömungskanal des Gegenstrombereichs ununterteilt ausgebildet ist. Die übrigen Strömungskanäle sind (unabhängig von einer Unterteilung des äußersten Strömungskanals des Gegenstrombereichs) im Allgemeinen ununterteilt ausgebildet.

Bei einer alternativen, ebenfalls bevorzugten Ausführungsform ist ein zusätzlicher Strömungskanal ausgebildet, welcher den äußersten Strömungskanal des Gegenstrombereichs umschließt, wobei der zusätzliche Strömungskanal an einem axialen Ende einen zusätzlichen Fluideinlass und an einem gegenüberliegenden axialen Ende den Fluidauslass aufweist. Im zusätzlichen Strömungskanal kann der Mantelstrom unabhängig vom Gegenstrom geführt werden. Aufgrund des Fluideinlasses (für den Gegenstrombereich) und des zusätzlichen Fluideinlasses (am zusätzlichen Strömungskanal) braucht keine Auftrennung eines Gesamtfluidstroms im Bereich des Fluidauslasses (und eines Fluiddurchlasses zum nächst inneren Strömungskanal) erfolgen, wodurch Verwirbelungen vermieden werden. Ebenso ist es grundsätzlich möglich, den Mantelstrom und den Gegenstrom unabhängig voneinander zu regeln, insbesondere zu temperieren und bezüglich des jeweiligen Durchflusses einzustellen.

Bevorzugt ist eine Weiterbildung dieser Ausführungsform, bei der der Fluideinlass und der zusätzliche Fluideinlass am selben axialen Endbereich der Temperiereinrichtung ausgebildet sind und an einen gemeinsamen Zulauf eines temperierenden Fluidstroms angeschlossen sind. Der gemeinsame Zulauf vereinfacht die Temperierung und ist platzsparend im NMR-Probenkopf. Allerdings ergibt sich bei dieser Weiterbildung das Verhältnis von Mantelstrom und Gegenstrom durch die Geometrie der Fluidführungen. Alternativ können daher auch separate Zuläufe für den Fluideinlass und den zusätzlichen Fluideinlass vorgesehen sein.

Bei einer vorteilhaften Ausführungsform der erfindungsgemäßen Temperiereinrichtung ist vorgesehen, dass eine axiale Wand, welche den äußersten Strömungskanal des Gegenstrombereichs oder den zusätzlichen Strömungskanal vom nächst inneren Strömungskanal abtrennt, in transversaler Richtung einen Wärmedurchgangskoeffizienten U_{AN} aufweist, und dass alle etwaigen übrigen axialen Wände, welche zwischen Strömungskanälen des Gegenstrombereichs liegen, und eine axiale Wand, die den innersten Strömungskanal vom Innenraum abgrenzt, in transversaler Richtung jeweils einen Wärmedurchgangskoeffizienten größer als U_{AN}, bevorzugt größer als 3*U_{AN}, ganz besonders bevorzugt größer als 10*U_{AN}, und weiter bevorzugt größer als 50*U_{AN}, aufweisen. Mit anderen Worten hat die axiale Wand, welche den äußersten Strömungskanal des Gegenstrombereichs oder den zusätzlichen Strömungskanal vom nächst inneren Strömungskanal abtrennt, wärmeisolierende Eigenschaften (und wirkt *nicht* als Wärmetauscher). Dadurch kann eine Verringerung des Temperaturgradienten des Fluidstroms am NMR-Probenröhrchen oder gar eine Umkehrung dieses Temperaturgradienten erreicht werden, insbesondere wenn der Fluideinlass und ggf. der zusätzliche Fluideinlass einerseits und andererseits der Fluidauslass und die Halterung des NMR-Probenröhrchens an gegenüberliegenden axialen Endbereichen ausgebildet sind. Der Wärmedurchgangskoeffizient kann aus der spezifischen Wärmeleitfähigkeit dividiert durch die Wandstärke bestimmt werden. Die Wand zwischen dem äußersten und dem nächst inneren Strömungskanal kann aus einem Material mit schlechterer Wärmeleitfähigkeit als die übrigen Wände gefertigt werden, oder auch mit deutlich größerer Wandstärke ausgeführt werden.

Bevorzugt ist eine Ausführungsform, bei der der Fluidauslass an einem axialen Ende des äußersten Strömungskanals der Temperiereinrichtung und/oder des nächst inneren Strömungskanals der Temperiereinrichtung ausgebildet ist, welches dem offenen ausgebildeten axialen Endbereich zugewandt ist. Ebenfalls bevorzugt ist der Fluideinlass (und ggf. auch der zusätzliche Fluideinlass) an dem axialen Ende des zugehörigen Strömungskanals ausgebildet, welches dem geschlossen ausgebildeten axialen Endbereich zugewandt ist. In diesem Fall behindern sich die Fluidzuführung und die Halterung des NMR-Probenröhrchens nicht; die Platzverhältnisse in einem typischen NMR-Probenkopf können gut ausgenutzt werden.

Bei einer besonders bevorzugten Ausführungsform ist vorgesehen, dass der Innenraum kreiszylindrisch ausgebildet ist, und dass die Strömungskanäle im Querschnitt kreisringförmig ausgebildet sind. Bei einem im Querschnitt kreisförmigen NMR-Probenröhrchen kann dann eine sehr gleichmäßige Umspülung des NMR-Probenröhrchens mit dem temperierenden Fluid erreicht werden; transversale Temperaturgradienten werden vermindert. Alternativ sind auch andere, insbesondere polygonale (etwa viereckige der sechseckige) Querschnitte des Innenraums und der Strömungskanäle möglich; eine Drehsymmetrie um die Achse des NMR-Probenröhrchens bzw. die zentrale Mittelachse des Innenraums ist jedoch bevorzugt.

Bei einer vorteilhaften Ausführungsform ist der Fluideinlass und/oder der zusätzliche Fluideinlass und/oder der Fluidauslass und/oder mindestens einer der Fluiddurchlässe durch mehrere, symmetrisch um eine Mittelachse des Innenraums verteilte Öffnungen ausgebildet. Dadurch ist eine gleichmäßige Umspülung des NMR-Probenröhrchens mit dem Fluid möglich; Temperaturgradienten werden reduziert. Wenn ein Fluideinlass mit mehreren Öffnungen ausgebildet ist, werden diese typischerweise über einen gemeinsamen Zulauf bespeist.

Ebenfalls vorteilhaft ist eine Ausführungsform, bei der der Fluideinlass und/oder der zusätzliche Fluideinlass und/oder der Fluidauslass und/oder mindestens einer der Fluiddurchlässe durch einen ringförmigen Spalt ausgebildet ist. Auch dadurch kann eine gleichmäßige Umspülung des NMR-Probenröhrchens erreicht werden. Falls ein ringförmiger Spalt an einem Fluideinlass genutzt werden soll, kann eine Vorkammer mit Überdruck eingerichtet werden, in die der Fluideinlass führt und von der aus der ringförmige Spalt gleichmäßig mit Fluid beströmt wird.

Bei einer bevorzugten Ausführungsform umfasst der Gegenstrombereich genau zwei ineinander geschachtelte Strömungskanäle. Dieser Aufbau ist relativ einfach und hat sich in der Praxis bewährt. Alternativ sind auch drei oder mehr Strömungskanäle möglich.

Vorteilhaft ist weiterhin eine Ausführungsform, bei der die Anzahl der ineinander geschachtelten Strömungskanäle des Gegenstrombereichs gerade ist. In der Regel sind der Fluideinlass und der Fluidauslass in gegenüberliegenden axialen Endbereichen ausgebildet, und der Fluideinlass ist dem offen ausgebildeten axialen Endbereich abgewandt. Dann kann die Fluidzufuhr vollständig an einem axialen Endbereich (meist unten), und die Fluidabfuhr vollständig am gegenüberliegenden axialen Endbereich (meist oben) ausgebildet werden. Dadurch wird ein kompakter Aufbau erreicht.

Ebenfalls bevorzugt ist eine Ausführungsform, bei der mindestens ein Strömungskanal eine HF-Spule enthält, insbesondere wobei die HF-Spule an der inneren Wand eines Strömungskanals aufsitzt. Durch eine Integration der HF-Spule oder HF-Spulen in die Temperiereinrichtung können sowohl die Temperiereinrichtung als auch die HF-Spulen nahe beim NMR-Probenröhrchen angeordnet werden. Die HF-Spule sitzt bevorzugt an der Außenseite einer axialen Wand der Temperiereinrichtung auf (und ist damit an der inneren der beiden axialen Wände eines Strömungskanals angeordnet). Bevorzugt werden je eine Hochfrequenz(=HF)-Spule im innersten Strömungskanal und im zweitinnersten Strömungskanal angeordnet (man beachte, dass der Spalt zwischen NMR-Probenröhrchen und der Wand des Innenraums hierbei nicht als Strömungskanal gezählt wird).

Weiterhin fällt in den Rahmen der vorliegenden Erfindung ein Verfahren zur Temperierung eines NMR-Probenröhrchens, wobei ein temperierender Fluidstrom nach dem Gegenstromprinzip in ineinander geschachtelten Strömungskanälen alternierend entlang einer axialen Erstreckungsrichtung des NMR-Probenröhrchens und dazu entgegengesetzt geführt wird, das dadurch gekennzeichnet ist, dass zusätzlich zum Fluidstrom nach dem Gegenstromprinzip ein temperierender Fluidstrom nach dem Mantelstromprinzip eingesetzt wird, wobei der Fluidstrom nach dem Mantelstromprinzip zumindest einen Teil des Bereichs, in welchem der Fluidstrom nach dem Gegenstromprinzip geführt wird, und zumindest einen Teil des NMR-Probenröhrchens umschliesst, wobei der Fluidstrom nach dem Mantelstromprinzip wenigstens 50% eines temperierenden Gesamtfluidstroms, definiert durch die Summe des Fluidstroms nach dem Mantelstromprinzip und des Fluidstroms nach dem Gegenstromprinzip, beträgt. Der Fluidstrom nach dem Gegenstromprinzip ("Gegenstrom") fließt zumindest teilweise weiter innen als der Fluidstrom nach dem Mantelstromprinzip ("Mantelstrom"). Der Gegenstrom umspült bevorzugt schließlich unmittelbar das NMR-Probenröhrchen, wohingegen der Mantelstrom den Gegenstrombereich oder Teile des Gegenstrombereichs umspült und dadurch den Gegenstrombereich "vortemperiert", also der gewünschten Zieltemperatur für das NMR-Probenröhrchen (im Vergleich zur Umgebung) näherbringt..Durch den Mantelstrom kann eine sehr hohe Temperierleistung am NMR-Probenröhrchen erreicht werden, wobei gleichzeitig durch den Gegenstrom ein sehr geringer Temperaturgradient am NMR-Probenröhrchen erreicht werden kann. Der (meist relativ hohe) Strömungswiderstand des Gegenstroms ist für den Mantelstrom nicht relevant und begrenzt daher die Temperierleistung nicht.

Bei einer bevorzugten Variante des erfindungsgemäßen Verfahrens wird der Fluidstrom nach dem Mantelstromprinzip lediglich einmal entlang der Erstreckungsrichtung des NMR-Probenröhrchens geführt. Der Mantelstrom braucht dann nicht umgelenkt zu werden und erfährt nur geringen Strömungswiderstand. Dadurch können hohe Mantelströme und somit hohe Temperierleistungen eingerichtet werden.

Somit weist der temperierende Gesamtfluidstrom einen ersten Teil für eine Temperierung nach dem Mantelstromprinzip und einen zweiten Teil für die Temperierung nach dem Gegenstromprinzip auf, wobei der erste Teil und der zweite Teil bevorzugt zunächst gemeinsam fließen, insbesondere in einem äußersten Strömungskanal einer Temperiereinrichtung, und danach aufgetrennt werden. Dadurch wird nur ein Zulauf (bzw. eine Quelle / ein Temperiersystem) für einen temperierenden Fluidstrom benötigt, und die Anzahl der benötigten Strömungskanäle kann klein gehalten werden. Diese Verfahrensvariante ist daher besonders einfach umzusetzen.

Bei einer vorteilhaften Weiterentwicklung dieser Verfahrensvariante wird der aufgetrennte zweite Teil vom axialen Temperaturgradienten im aufgetrennten ersten Teil oder im gemeinsam fließenden Gesamtfluidstrom oder im aufgetrennten zweiten Teil (GS) in einem stromaufwärts liegenden Abschnitt thermisch isoliert. Dadurch kann ein axialer Temperaturgradient im zweiten Teil erzeugt werden, der umgekehrt zum axialen Temperaturgradienten im ersten Teil oder im Gesamtstrom oder im stromaufwärts liegenden Abschnitt des zweiten Teils verläuft. Damit ist es möglich, besonders geringe axiale Temperaturgradienten im NMR-Probenröhrchen zu erhalten.

Eine andere, ebenfalls bevorzugte Variante des erfindungsgemäßen Verfahrens sieht vor, dass der Fluidstrom nach dem Gegenstromprinzip und der Fluidstrom nach dem Mantelstromprinzip vollständig separat geführt werden, und insbesondere separat geregelt und temperiert werden. Dadurch kann das Verhältnis von Mantelstrom zu Gegenstrom flexibel eingestellt werden, insbesondere zur individuellen Anpassung der Messbedingungen an bestimmte Probensysteme oder experimentelle Abläufe. Die getrennte Führung von Mantelstrom und Gegenstrom kann auch Verwirbelungen (und damit schlechte Temperierleistungen) reduzieren helfen.

Bevorzugt ist dabei eine Weiterentwicklung dieser Verfahrensvariante, bei der der Fluidstrom nach dem Gegenstromprinzip vom Fluidstrom nach dem Mantelstromprinzip oder vom Fluidstrom nach dem Gegenstromprinzip in einem stromaufwärts liegenden Abschnitt thermisch isoliert wird. Dies ermöglicht eine Umkehrung der Temperaturgradienten im Gegenstrom relativ zum Mantelstrom bzw. zum stromaufwärts liegenden Abschnitt des Gegenstroms, was für eine besonders gleichmäßige Temperierung des NMR-Probenröhrchens genutzt werden kann.

In den Rahmen der vorliegenden Erfindung fällt auch die Verwendung einer erfindungsgemäßen, oben beschriebenen Temperiereinrichtung, insbesondere in einem oben beschriebenen, erfindungsgemäßen Verfahren, zur Temperierung eines NMR-Probenröhrchens, welches im Innenraum der Temperiereinrichtung angeordnet ist. Durch Verwendung der erfindungsgemäßen Temperiereinrichtung kann eine hohe Temperierleistung (und somit die Einrichtung von großen Temperaturdifferenzen zur Umgebung und auch eine schnelle Einstellung der Zieltemperatur am NMR-Probenröhrchen) bei geringen (axialen) Temperaturgradienten im NMR-Probenröhrchen erreicht werden. Erfindungsgemäss ist der Mantelstrom wenigstens 50% des gesamten Fluidstroms (Summe aus Mantelstrom und Gegenstrom).

Besonders bevorzugt ist eine Variante der erfindungsgemäßen Verwendung, bei der als Fluid ein Gas, insbesondere Luft oder Stickstoff, verwendet wird. Luft und Stickstoff sind kostengünstig und stören NMR-Messungen nicht merklich. Bevorzugt ist das Gas entfeuchtet.

Vorteilhaft ist eine Verwendungsvariante, wobei sich im Fluidstrom an der Außenseite des NMR-Probenröhrchens ein Temperaturgradient einstellt, welcher umgekehrt zum Temperaturgradienten im Fluidstrom im äußersten Strömungskanal der Temperiereinrichtung verläuft. Sofern der Fluideinlass (und ggf. auch der zusätzliche Fluideinlass) dem offen ausgebildeten axialen Endbereich (und damit der Röhrchenhalterung) abgewandt ist (gegenüber liegt), kann der umgekehrte Temperaturgradient der Temperaturbrücke durch die Röhrchenhalterung entgegenwirken, und es kann ein besonders geringer oder verschwindender Temperaturgradient im NMR-Probenröhrchen bzw. in der darin enthaltenen Messprobe erreicht werden.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine schematische axiale Querschnittsdarstellung einer erfindungsgemäßen Temperiereinrichtung, dargestellt ohne HF-Spulen;
- Fig. 1b: eine schematische axiale Querschnittsdarstellung der erfindungsgemäßen Temperiereinrichtung von Fig. 1a, dargestellt mit HF-Spulen, aber ohne Fluidstrom;
- Fig. 1c: eine schematische, radiale Querschnittsdarstellung der erfindungsgemäßen Temperiereinrichtung von Fig. 1a auf der Höhe der Ebene Ic.
- Fig. 2a: ein Temperaturdiagramm sowie eine schematische Querschnittsdarstellung der Gasführung einer erfindungsgemäßen Temperiereinrichtung (entsprechend Fig. 1a-1c), mit kleinem Wärmeverlust Q2;
- Fig. 2b: ein Temperaturdiagramm sowie eine schematische Querschnittsdarstellung der Gasführung einer erfindungsgemäßen Temperiereinrichtung wie in Fig. 2a, jedoch mit großem Wärmeverlust Q2;
- Fig. 2c: ein Temperaturdiagramm sowie eine schematische Querschnittsdarstellung der Gasführung einer erfindungsgemäßen Temperiereinrichtung wie in Fig. 2a, jedoch mit Umkehrung des Temperaturgradienten mittels einer wärmeisolierenden Zylinderwand;
- Fig. 3: eine schematische, axiale Querschnittsdarstellung einer erfindungsgemäßen Temperiereinrichtung, mit einem in einem oberen Bereich zwei Abteilungen umfassenden äußersten Strömungskanal;
- Fig. 4: eine schematische, axiale Querschnittsdarstellung einer erfindungsgemäßen Temperiereinrichtung, mit vier ineinander geschachtelten Strömungskanälen;
- Fig. 5: eine schematische, axiale Querschnittsdarstellung einer erfindungsgemäßen Temperiereinrichtung, mit einem gemeinsamen Zulauf für einen zusätzlichen Strömungskanal und einen Gegenstrombereich;
- Fig. 6: eine schematische, axiale Querschnittsdarstellung einer erfindungsgemäßen Temperiereinrichtung, mit getrennten Zuläufen für einen zusätzlichen Strömungskanal und einen Gegenstrombereich.

Die Erfindung betrifft die Temperierung von NMR-Probenröhrchen mit erweitertem Leistungsbereich.

NMR-Proberöhrchen werden üblicherweise bei einer definierten Temperatur betrieben (vermessen), welche über das NMR-Spektrometer eingestellt wird und stabil gehalten werden soll. Eine solche Konstanthaltung der Temperatur ist notwendig, weil die im NMR erzeugten Spektren eine Abhängigkeit von der Temperatur der Probesubstanz (Messprobe) zeigen, welche dazu führt, dass Änderungen in der Umgebungstemperatur schlussendlich in das Messresultat eingehen (Verschiebung einzelner Frequenzlinien). Je nach Experiment sind diese Effekte störend und verfälschen das Bild.

Meist verwendete Probenröhrchen in der NMR sind aus Borosilikat (Glas) gefertigt, rund zylindrisch ausgebildet und haben einen Außendurchmesser von 5 mm und eine gesamte Länge von rund 7" (ca. 18 cm). Das aktive Volumen, aus dem die NMR-Messinformationen gewonnen werden, befindet sich im unteren Drittel des Röhrchens und erstreckt sich üblicherweise über rund 25 mm Länge des Probenröhrchens (Messfenster). Das aktive Volumen ist von NMR-Spulen (HF-Spulen) umgeben, welche die Atome in dieser Region über ein zum Hauptfeld (BO-Feld) orthogonal stehendes Anregungsfeld (B1 Feld) homogen anregen. Im aktiven Volumen geben die angeregten Atome ein schwaches magnetisches Wechselfeld ab, das wieder von entsprechenden NMR-Spulen empfangen wird. Um möglichst aus allen Teilen des aktiven Volumens gleiche Beiträge zum magnetischen Wechselfeld zu erhalten, ist eine möglichst gleiche Temperatur im gesamten aktiven Volumen erforderlich, d.h. der Temperaturgradient soll Null anstreben.

Hierbei muss beachtet werden, dass längs des Probenröhrchens auch ein Wärmeabfluss in die Richtung erfolgt, wo das Probenröhrchen nicht mehr kontrolliert temperiert wird, etwa im Bereich einer Halterung für das NMR-Probenröhrchen.

Heutige Anforderungen an die Temperierung von NMR-Messproben gehen bis zu einer Regelstabilität der Temperatur von +/-0.01°K bei einer Stabilität der Umgebungstemperatur von +/- 1°C. Weiter wird eine Ausgeglichenheit der Temperatur über dem aktiven Volumen des Probenröhrchens gefordert, welche mittels eines Temperaturgradienten beschrieben wird. Ein typischer geforderter Temperaturgradient liegt in der Größenordnung von 0.1°K/cm oder besser, wenn man den Temperaturgradienten linear über die Längsachse des Probenröhrchens versteht, oder absolut in der Größenordnung 0.3°K oder besser (größte Temperatur minus geringste Temperatur innerhalb des aktiven Volumens, welches sich z.B. über 25 mm axiale Länge erstreckt).

Temperierungseinrichtungen des Standes der Technik weisen eine geringe Temperierleistung oder einen hohen Temperaturgradienten auf, und/oder sind schwierig zu konstruieren. Mit der vorliegenden Erfindung wird auf einfache Weise eine erhöhte Temperierleistung ermöglicht, wobei ein temperierender Fluidstrom mit geringem positiven und sogar einem negativen Temperaturgradienten (d.h. eine gegenläufige Temperierung in Hinblick auf den Wärmeeintrag/verlust durch eine Probenröhrchenhalterung) eingerichtet werden kann ("Umlenktrennung mit beschränkter Leitfähigkeit").

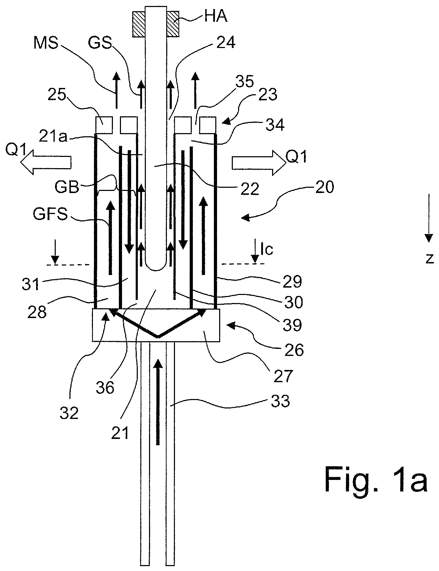

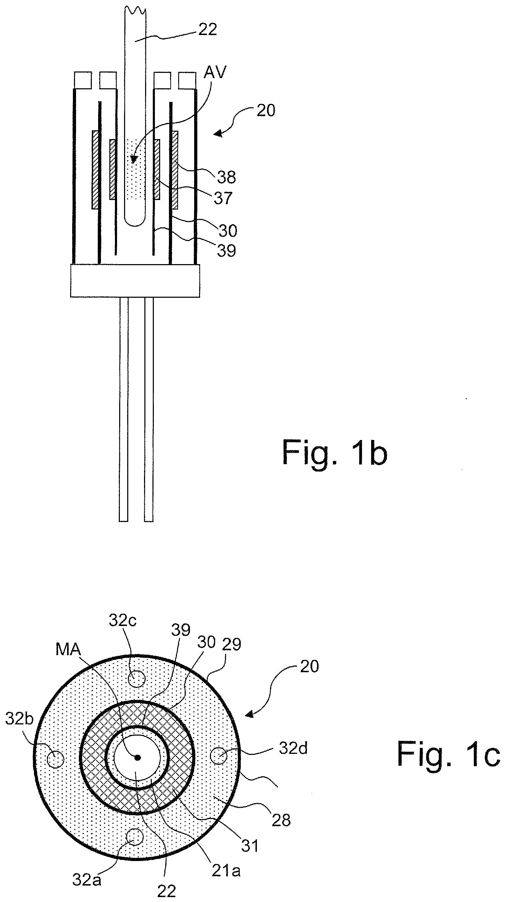

Die **Figuren 1a****,** **1b und 1c** zeigen schematisch eine Ausführungsform einer erfindungsgemäßen Temperiereinrichtung 20 im axialen Schnitt (Fig. 1a, vereinfacht in Fig. 1b) und im horizontalen (radialen) Schnitt (Fig. 1c, vgl. Schnittlinie Ic in Fig. 1a). Die Temperiereinrichtung 20 gestattet das Temperieren eines NMR-Probenröhrchens 22 mit einem Fluidstrom (vgl. Pfeile in Fig. 1a). Als Fluid wird typischerweise ein Gas eingesetzt, etwa Luft oder Stickstoff; die Temperatur des (zuströmenden) Fluids ist (in nicht näher dargestellter Weise) definiert eingeregelt, typischerweise auf eine Temperatur zwischen -150°C und +150°C.

Die Temperiereinrichtung 20 weist einen zylindrischen (hier kreiszylindrischen) Innenraum 21 auf, in welchem ein NMR-Probenröhrchen 22 angeordnet werden kann. Die Temperiereinrichtung 20 ist dazu im oberen axialen Endbereich 23 offen zum Innenraum 21 ausgebildet, vgl. die Öffnung 24 im oberen Abschlussstück 25. Im unteren axialen Endbereich 26 ist die Temperiereinrichtung 20 geschlossen zum Innenraum 21 ausgebildet, vgl. das untere Abschlussstück 27. Das NMR-Probenröhrchen 22 ragt mit seinem freien, unteren Ende in den Innenraum 21 hinein, und am oberen Ende des Probenröhrchens 22 ist eine Halterung HA, etwa ein Spinner, angeordnet (nur angedeutet in der Fig. 1a).

Um den Innenraum 21 herum bildet die Temperiereinrichtung 20 mehrere Strömungskanäle für den Fluidstrom aus. Ein äußerster Strömungskanal 28 wird durch die axiale Wände 29 und 30 begrenzt, und ein innerster Strömungskanal 31 wird durch die axialen Wände 30 und 39 begrenzt. Die axiale Wand 39 begrenzt gleichzeitig den Innenraum 21. Die Wände 29, 30, 39 sind typischerweise aus Glas gefertigt.

Die Strömungskanäle 28, 31 sind jeweils (hier) kreisringförmig ausgebildet und liegen ineinander. Sie sind konzentrisch zum (hier) kreiszylindrischen Innenraum 21 (vgl. Fig. 1c) angeordnet und erstrecken sich parallel zur axialen Richtung (z-Richtung) .

Der äußerste Strömungskanal 28 weist an seinem unteren Ende einen Fluideinlass 32 auf, der hier mit vier Öffnungen 32a-32d ausgebildet ist, die jeweils aus einem gemeinsamen Zulauf 33 bespeist werden. Die Öffnungen 32a-32d sind symmetrisch (gleichmäßig) um eine Mittelachse MA des Innenraums 21 angeordnet. Dadurch kann im gesamten Strömungskanal 28 ein näherungsweise gleichförmiger Fluidstrom nach oben (vgl. Pfeile) eingerichtet werden.

Am oberen Ende des äußersten Strömungskanals 28 ist ein Fluiddurchlass 34 zum nächst inneren, hier dem innersten Strömungskanal 31 ausgebildet. Am einfachsten ist dieser Fluiddurchlass 34 als ein ringförmiger Spalt ausgebildet. Ebenso ist am oberen Ende des äußersten Strömungskanals 28 ein Fluidauslass 35 ausgebildet; dieser Fluidauslass 35 kann ebenfalls als ringförmiger Spalt oder auch mit symmetrisch verteilten Öffnungen ausgebildet sein, hier im oberen Abschlussstück 25.

Ein erster Teil (Mantelstromanteil MS) des Gesamtfluidstroms GFS des äußersten Strömungskanals 28 gelangt durch den Fluidauslass 35 aus der Temperiereinrichtung 20 heraus, und ein zweiter Teil (Gegenstromanteil GS) gelangt in den zweiten Strömungskanal 31. Dieser zweite Teil GS strömt im zweiten Strömungskanal 31 nach unten, also entgegen der Strömungsrichtung im benachbarten äußersten Strömungskanal 28.

Am unteren Ende des zweiten Strömungskanals 31 ist ein weiterer Fluiddurchlass 36, bevorzugt als ringförmiger Spalt, ausgebildet. Dieser Fluiddurchlass 36 führt in den Innenraum 21. Der zweite Teil GS des Gesamtfluidstroms kann dann (nach Umlenkung am geschlossenen axialen Endbereich 26) an der Außenseite des NMR-Probenröhrchens 22 entlang im axialen Spalt 21a zwischen Wand 39 und Probenröhrchen 22 nach oben strömen, und durch den vom Probenröhrchen 22 nicht versperrten Teil der Öffnung 24 ausströmen. Der Fluidstrom an der Außenseite des NMR-Probenröhrchens 22 ist wiederum entgegengesetzt zum Fluidstrom im innersten Strömungskanal 31.

Der Mantelstromanteil MS des Gesamtfluidstroms GFS im äußersten Strömungskanal 28 umschließt somit radial den Gegenstromanteil GS im Strömungskanal 31 und im Innenraum 21 sowie den unteren Teil des NMR-Probenröhrchens 22, und kann so die Temperierung des NMR-Probenröhrchens 22 durch den Gegenstromanteil GS unterstützen. Der Mantelstromanteil MS fließt im äußersten Strömungskanal 28 gemeinsam mit dem Gegenstromanteil GS im Gegenstrombereich GB; der nächst innere Strömungskanal 31 wird jedoch vom Mantelstromanteil MS nicht durchströmt (Man beachte, dass der Gasauslass 35 auch oben am Strömungskanal 31 ausgebildet sein könnte; in diesem Fall würde jedenfalls der untere Teil des Strömungskanals 31 nicht vom Mantelstromanteil MS durchflossen).

In Fig. 1c kann die Strömungsrichtung des Fluids in den verschiedenen Bereichen der Temperiereinrichtung 20 ersehen werden; gepunktete Flächen deuten eine Strömung auf den Betrachter zu (nach oben in Fig. 1a) an, und ein Quadratmuster deutet eine Strömung vom Betrachter weg (nach unten in Fig. 1a) an. Die Strömungsrichtung wechselt nach innen von Strömungskanal zu Strömungskanal, und auch wieder zum Innenraum 21.

Die Strömungskanäle 28 und 31 bilden einen Gegenstrombereich GB, in welchem sich die Strömungsrichtung des temperierenden Fluids zum jeweils benachbarten Strömungskanal axial umkehrt. In der Ausführungsform der Figuren 1a-1c gehören alle Strömungskanäle 28, 31 zum Gegenstrombereich GB, und der Strömungskanal 28 ist gleichzeitig der äußerste Strömungskanal der Temperiereinrichtung 20 als auch der äußerste Strömungskanal des Gegenstrombereichs GB.

Außen auf der innersten axialen Wand 39 und außen auf der zweitinnersten axialen Wand 30 der Temperiereinrichtung 20 ist je eine Hochfrequenz(=HF)-Spule 37, 38 angeordnet, etwa axial aufgeschoben. Mit den HF-Spulen 37, 38 können Atome in einem aktiven Volumen AV (gepunktet in Fig. 1b) im NMR-Probenröhrchen 22 bzw. der darin enthaltenen Messprobe angeregt werden (B1-Feld) und Spinechos aus dem aktiven Volumen AV empfangen werden. Das im Wesentlichen kreiszylindrische NMR-Probenröhrchen 22 hat typischerweise einen Außendurchmesser von 5 mm und eine axiale Länge von ca. 7" (ca. 18 cm) und ist aus Borosilikatglas gefertigt. Das aktive Volumen befindet sich im unteren Drittel des NMR-Probenröhrchens 22 und hat typischerweise eine axiale Erstreckung von ca. 25 mm.

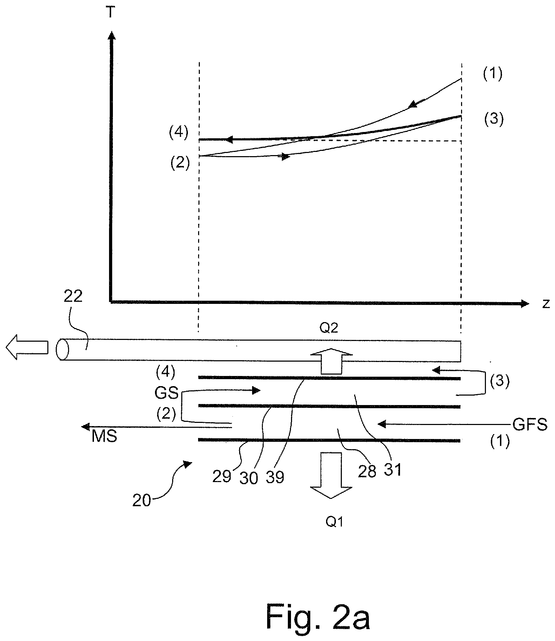

Im folgenden sollen die Temperaturverhältnisse und die Wärmeströme in einer erfindungsgemäßen Temperiereinrichtung anhand von verschiedenen Modellüberlegungen näher erläutert werden, vgl. dazu Fig. 2a-2c. Beispielhaft wird ein beheizender Gasstrom für das NMR-Probenröhrchen erläutert; die Ausführungen gelten entsprechend für einen kühlenden Gasstrom.

**Fig. 2a** zeigt unten schematisch den Aufbau einer zylindrischen Gasführung in einer erfindungsgemäßen Temperiereinrichtung (wie in Fig. 1a-1c vorgestellt) im Querschnitt, wobei aus Symmetriegründen nur eine Hälfte zusammen mit dem NMR-Proberöhrchen 22 dargestellt ist. Wand (Zylinder) 29 stellt den äußeren Abschluss der Gasführung in der Temperiereinrichtung dar und hat einen gewissen Wärmeverlust Q1 nach außen. Der Wärmeverlust Q1 wird hier als über die gesamte axiale Länge der Wand 29 in gleicher Stärke wirkend angenommen, gegeben durch einen überall identischen Wärmeübergang. Die Wand 29 soll in diesem Modell in transversaler Richtung (senkrecht zu z) keinen Wärmewiderstand haben, in longitudinaler Richtung (z-Richtung, axiale Richtung) kann ein gewisser Widerstand bis zu kompletten Nichtleitung von Wärme vorausgesetzt werden.

Der Temperiergasstrom tritt bei (1) ein (vgl. Gaseinlass 32 in Fig. 1a) und kühlt sich wegen des peripheren Wärmeverlustes Q1 im äußersten Strömungskanal 28 kontinuierlich ab und erfährt somit einen positiven Temperaturgradienten. Das heißt, der Gasstrom ist an der Eintrittsstelle (1) wärmer als an der Austrittsstelle (2) (Fluidauslass 35 in Fig. 1a) bzw. die Temperatur nimmt mit positiver z-Richtung zu. Der zusätzliche Auslass an Stelle (2) (Fluidauslass 35 in Fig. 1a) lässt einen Mantelstrom MS zu, der einen deutlich höheren Volumenstrom hat als der Volumenstrom, welcher durch die Gasumlenkung am Proberöhrchen 22 vorbeigeführt wird (Gegenstromanteil GS).

Der Mantelstrom MS dient der Kompensation der Verluste Q1im Richtung nach außen und der schnellen Erzeugung eines Temperaturmantels, damit das gesamte System möglichst in kurzer Zeit auf extreme Temperaturen kommt. Praktische Temperaturen für das NMR-Probenröhrchen 22 reichen von -150°C bis +150°C, die man mittels Stickstoffkühlung bzw. elektrischer Heizung erzeugt. Der durch den Mantelstrom MS im Zusammenspiel mit ausreichend engen Austrittsöffnungen (Fluidauslass 35) bei (2) erzeugte Überdruck im sonst geschlossenen System führt zum verbleibenden Volumenstrom (Gegenstrom GS), welcher die Gasumlenkungen passiert und am Proberöhrchen 22 nach oben (in Fig. 2a nach links) vorbeistreicht. Damit wird dieses System sehr effizient in der Temperierung, was experimentell und simulationstechnisch nachgewiesen ist.

Der Temperiergasstrom GS, der bei (2) umgelenkt wird, strömt dann durch den nächst inneren Strömungskanal 31, begrenzt durch die Wände (Zylinder) 30 und 39, und wird bei (3) nochmals umgelenkt und verlässt das Temperiersystem (die Temperiereinrichtung 20) Richtung oben (in Fig. 2a nach links) am Proberöhrchen 22 vorbei.

In der Modellannahme von Fig. 2a sind die Umlenkungen jeweils gleich und die Zylinderwände 39, 30, 29 haben ähnliche Wärmeeigenschaften . Die Strömungskanäle 28, 31 und Wände 30, 39 stellen eigentlich einen Wärmetauscher dar, welcher in sich das Temperaturprofil ausgleicht. Dies ist dargestellt in der in Fig. 2a oben liegenden Grafik, die die Temperatur im Fluidstrom nachvollzieht. Die Eintrittstemperatur bei (1) senkt sich Richtung (2) ab. Nach der Umlenkung erwärmt sich der Gasstrom von (2) nach (3) über die wärmeleitende Zylinderwand 30 und hat bei (3) wieder eine erhöhte Temperatur. Bei der fortgeführten Umlenkung von (3) nach (4) wird diese Wärme wieder etwas abgebaut, einerseits am Proberöhrchen 22 (Wärmeverlust Q2), andererseits an der Wand (Zylinderwand) 39.

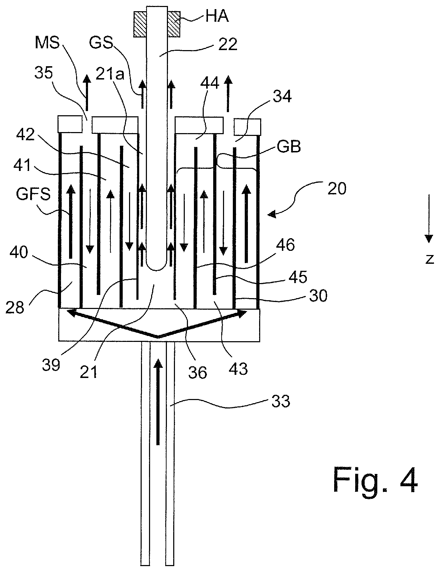

Wie man am Verlauf der Kurven gem. Fig. 2a sieht, geschieht so etwas wie eine Ausmittelung des Temperaturgradienten dank des Wärmeaustauschs über die Zylinderwände 30 und 39. Je mehr Stufen dieser Tauscher hat, desto ausgeglichener wird das Temperaturprofil am Ende; beispielsweise könnten sich für ein noch ausgeglicheneres Temperaturprofil zwei weitere Strömungskanäle innen an den Strömungskanal 31 (mit alternierendem Gasstrom) anschließen, bevor der Gasstrom in den Innenraum zum Probenröhrchen 22 geleitet wird (vgl. Fig. 4).

Das System von Figur 2a ist somit in der Lage, im Fluidstrom am NMR-Probenröhrchen 22 von (3) nach (4) (also im Spalt 21a, vgl. Fig. 1a) einen lediglich geringen, positiven Temperaturgradienten, oder im Grenzfall einen nach Null verschwindenden Temperaturgradienten, einzustellen. Mit diesem System kann vorteilhafter Weise eine Temperierung eines Proberöhrchens 22 mit einem vergleichsweise flachen Temperaturprofil erfolgen.

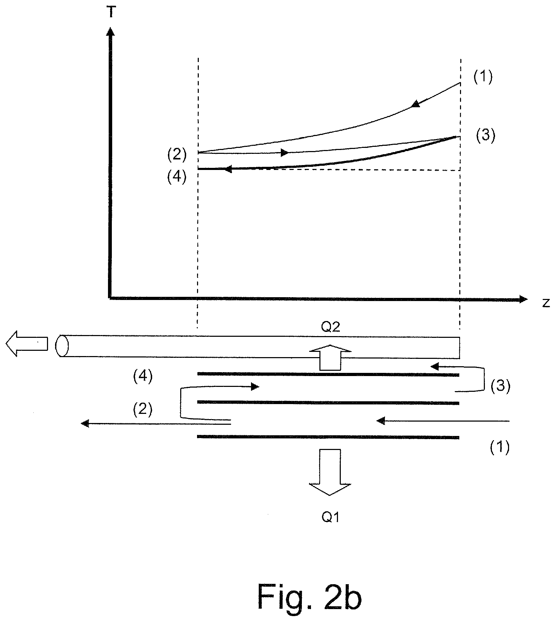

**Fig. 2b** illustriert ein Modell entsprechend dem Modell von Fig. 2a, jedoch bei Annahme eines größeren Wärmeverlusts Q2 im Vergleich zum Modell von Fig. 2a. In diesem Fall sinkt die Temperatur in allen Strömungsabschnitten stärker ab, und insbesondere bleibt die Temperatur bei (4) unter der Temperatur bei (2).

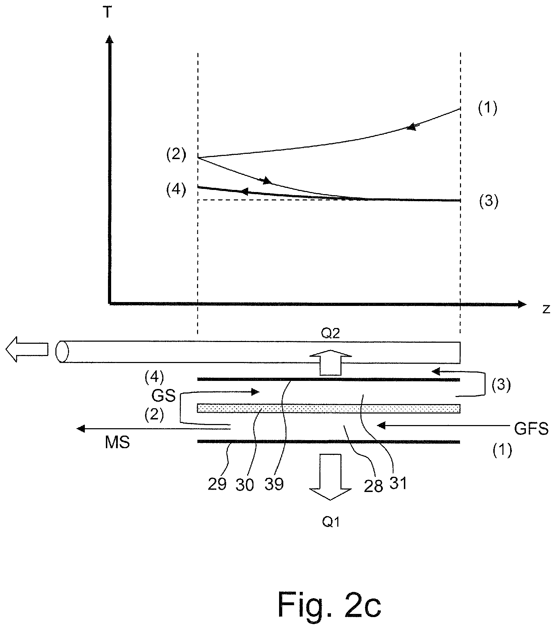

In **Fig. 2c** wird das Modell von Fig. 2a dadurch variiert, dass für die Zylinderwand 30 angenommen wird, dass sie in transversaler Richtung (senkrecht zu z) mäßig bis stark isolierend ist, d.h. es findet wenig oder kein Wärmeaustausch statt zwischen dem äußeren Strömungskanal 28 und dem nächst inneren Strömungskanal 31, also von (2) nach (3). Die Wände 29 und 39 sind weiterhin als in transversaler Richtung mit verschwindendem Wärmeleitungswiderstand angenommen werden.

Die sich dann einstellenden Temperaturverläufe im Gasstrom sind im oberen Teil von Fig. 2c dargestellt. Die Eintrittstemperatur bei (1) senkt sich Richtung (2) ab, einzig gegeben durch die Verluste Q1 nach außen. Nach der Umlenkung bei (2) erfolgt eine weitere Abkühlung des Gasstroms, da er Energie nach innen Richtung Zylinderwand 39 abgibt. Die Temperatur sinkt also von (2) nach (3) ab. Nach der letzten Umlenkung bei (3) kann sich der Gasstrom aber wieder über die Zylinderwand 39 leicht aufwärmen in negativer z-Richtung. Damit wird jetzt erstmals ein negativer Temperaturgradient im Gasstrom an der Außenseite des Probenröhrchens 22 erzeugt, welcher dem Eigenverlust des Proberöhrchens nach oben entgegenwirkt. Mit anderen Worten, das Temperiergas am NMR-Probenröhrchen hat hier eine zum gehaltenen Ende des Probenröhrchens hin zunehmende Temperatur, und kann somit die Kühlung des Probenröhrchens an der Halterung ausgleichen. Im Ergebnis kann dadurch im Probenröhrchen ein verschwindender Temperaturgradient erzeugt werden.

Vereinfacht kann gesagt werden, dass die isolierte Zylinderwand 30 im Prinzip die Einströmrichtung in den Wärmetauscher dreht, daher wechselt das Vorzeichen des resultierenden bzw. verbleibenden Temperaturgradienten im Gasstrom.

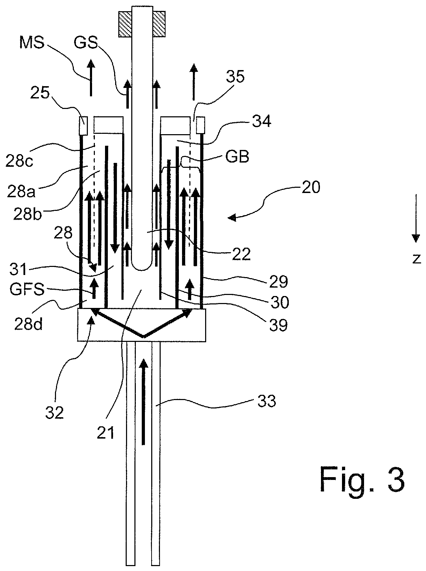

Die **Fig. 3** zeigt eine alternative Ausführungsform einer erfindungsgemäßen Temperiereinrichtung 20. Im folgenden werden vor allem die Unterschiede zur Ausführungsform von Fig. 1a erläutert.

In der gezeigten Ausführungsform weist der äußerste Strömungskanal 28 in seinem oberen (dem Gasauslass 35 zugewandten) Teil zwei Abteilungen 28a, 28b auf, die durch eine axiale (zylindrische) Zwischenwand 28c voneinander getrennt sind; die Zwischenwand 28c erstreckt sich hier vom oberen Abschlussstück 25 über ca. 2/3 der axialen Länge des äußersten Strömungskanals 28. Die axiale Zwischenwand 28c ist typischerweise aus Glas gefertigt.

Der Fluideinlass 32 mündet hier in einen unteren, gemeinsamen Abschnitt 28d des Strömungskanals 28, von dem wiederum beide Abteilungen 28a, 28b abgehen, so dass auch beide Abteilungen 28a, 28b jeweils einen Teil des aus dem Zulauf 33 kommenden gesamten Fluidstroms GFS erhalten. Die Fluidströme in beiden Abteilungen 28a, 28b sind gleichgerichtet (hier nach oben).

Die äußere Abteilung 28a führt zum Fluidauslass 35, aus dem der Mantelstromanteil MS entweicht. Die innere Abteilung 28b, welche den Gegenstromanteil GS leitet, führt zum Fluiddurchlass 34 und damit in den nächst inneren Strömungskanal 31.

In dieser Ausführungsform wird also der Gesamtfluidstrom GFS am Übergang des gemeinsamen Abschnitts 28d zu den Abteilungen 28a, 28b, also am unteren Ende der Zwischenwand 28c, aufgetrennt (aufgeteilt). Dadurch werden Verwirbelungen im Bereich Fluidauslasses 35 und des Fluiddurchlasses 34 reduziert.

Alternativ (vgl. Fig. 1a) ist es auch möglich, alle Strömungskanäle 28, 31, und insbesondere den äußersten Strömungskanal 28, ununterteilt (ohne eine axiale Zwischenwand) auszubilden.

Die **Fig. 4** zeigt eine weitere Ausführungsform einer erfindungsgemäßen Temperiereinrichtung 20, bei der insgesamt vier Strömungskanäle 28, 40, 41, 42 vorgesehen sind. Es werden wiederum vor allem die Unterschiede zur Ausführungsform von Fig.1a erläutert.

Der äußerste Strömungskanal 28 weist an seinem unteren Ende den Gaseinlass 32 für den Gesamtfluidstrom GFS auf. Am oberen Ende des zweitäußersten Strömungskanals 40 ist der Fluidauslass 35 ausgebildet; hier strömt der Mantelstromanteil MS aus; der Mantelstromanteil MS durchfließt also nur einen sehr kleinen, oberen Teil des Strömungskanals 40, nicht aber dessen unteren Teil. Der Gegenstromanteil GS strömt weiter durch die Strömungskanäle 40, 41, 42 und im Innenraum 21 am Probenröhrchen 22 vorbei.

Die Strömungskanäle 28, 40, 41, 42 sind durch Fluiddurchlässe 34, 43, 44 (etwa ringförmige Spalte) in den Wänden 30, 45, 46 bzw. an deren Enden so miteinander verbunden, dass sich die (axiale) Strömungsrichtung des Fluids zum jeweils benachbarten Strömungskanal umkehrt ("alternierende Strömungsrichtung"), vgl. die Pfeile in Fig. 4. Alle Strömungskanäle 28, 40, 41, 42 gehören zum Gegenstrombereich GB.

Durch die große Anzahl von Strömungskanälen (hier vier, ohne den Spalt 21a), durch die der Gegenstromanteil GS geleitet wird, kann ein sehr ausgeglichenes axiales Temperaturprofil (über die z-Richtung) im Fluidstrom im Spalt 21a am Probenröhrchen 22 erreicht werden.

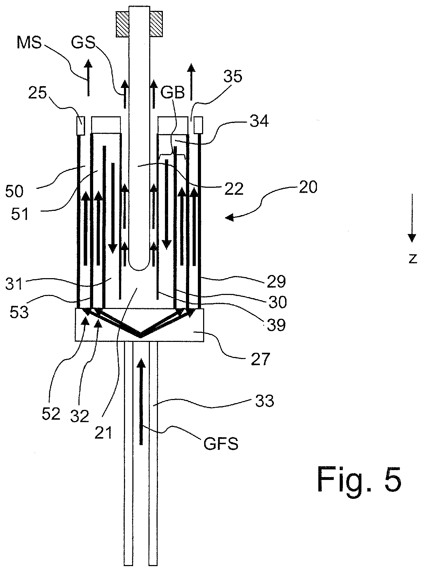

**Fig. 5** zeigt eine weitere Ausführungsform einer erfindungsgemäßen Temperiereinrichtung 20. Es werden wiederum vor allem die Unterschiede zur Ausführungsform von Fig. 1a erläutert.

In dieser Ausführungsform wird der Gesamtfluidstrom GFS im gemeinsamen Zulauf 33 im unteren Abschlussstück 27 auf den Fluideinlass 32 und einen zusätzlichen Fluideinlass 52 aufgeteilt.

Der Fluideinlass 32 mündet in einen äußersten Strömungskanal 51 des Gegenstrombereichs GB. Durch die Strömungskanäle 51, 31 des Gegenstrombereichs GB und im Innenraum 21 entlang der Außenseite des NMR-Probenröhrchens 22 fließt der Gegenstromanteil GS, wobei die Flussrichtung alterniert.

Der zusätzliche Fluideinlass 52 mündet in einen zusätzlichen Strömungskanal 50, in welchem der Mantelstromanteil MS geführt wird. Der zusätzliche Strömungskanal 50 bzw. der Mantelstromanteil MS umschließen hier radial alle Strömungskanäle 51, 31 des Gegenstrombereichs GB und auch den Innenraum 21, in welchem ebenfalls der Gegenstromanteil GS fließt und in welchem der untere Teil des NMR-Probenröhrchens 22 angeordnet ist. Der zusätzliche Strömungskanal 50 ist durch eine axiale Wand 53 vom nächst inneren Strömungskanal 51 getrennt; diese Wand 53 weist keinen Gasdurchlass auf. An oberen Ende des zusätzlichen Strömungskanals 50 ist der Gasauslass 35 ausgebildet, durch den der Mantelstromanteil MS entweicht; der Mantelstromanteil MS hat dann die z-Erstreckung des im Innenraum 21 eingeschlossenen unteren Teils des NMR-Probenröhrchens 22 lediglich einmal passiert.

Durch die Aufteilung des Gesamtfluidstroms GFS im unteren Abschlussstück 27 werden Verwirbelungen im Bereich des Fluidauslasses 35 und des Gasdurchlasses 34 vermieden.

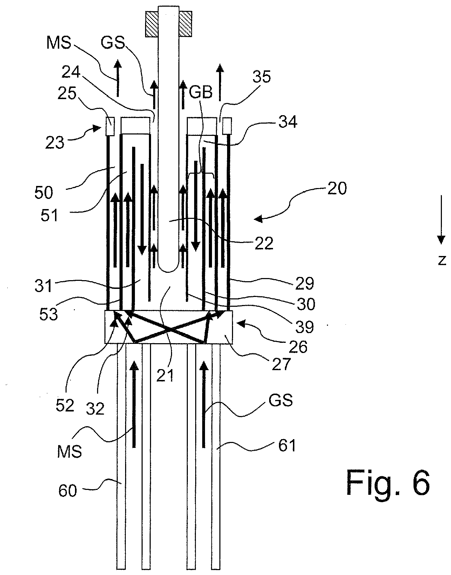

In **Fig. 6** wird eine weitere Ausführungsform einer erfindungsgemäßen Temperiereinrichtung gezeigt, welche der Ausführungsform von Fig. 5 in großen Teilen entspricht; es werden daher vor allem die Unterscheide zur Ausführungsform von Fig. 5 erläutert.

In der gezeigten Ausführungsform werden separate Zuläufe 60, 61 für einen Fluidstrom MS nach dem Mantelstromprinzip ("Mantelstrom") und einen Fluidstrom GS nach dem Gegenstromprinzip ("Gegenstrom") eingesetzt. Mantelstrom und Gegenstrom können insbesondere separat temperiert und separat bezüglich des Flusses geregelt werden. Beide Zuläufe 60, 61 sind hier an das untere Abschlussstück 27 angeschlossen.

Der Zulauf 60 bespeist den zusätzlichen Strömungskanal 50 über den zusätzlichen Fluideinlass 52, wobei der Mantelstrom MS nach einmaligem Passieren des NMR-Probenröhrchens 22 am Fluidauslass 35 ausströmt. Der Zulauf 61 bespeist den äußersten Strömungskanal 51 des Gegenstrombereichs GB über den Fluideinlass 32, wobei der Gegenstrom GS nacheinander alle Strömungskanäle 51, 31 des Gegenstrombereichs GB und den Innenraum 21 an der Außenseite des Probenröhrchens 22 passiert und dann zur Öffnung 24 ausströmt.

Man beachte, dass bevorzugt alle Zuläufe 60, 61 bzw. Fluideinlässe 32, 52 am geschlossen ausgebildeten Endbereich 26, und der Fluidauslass 35 am offen ausgebildeten Endbereich 23 ausgebildet sind, um einen kompakten Aufbau zu erhalten.

Falls eine Gradientenumkehr in der Ausführungsform von Fig. 6 gewünscht ist, sollte die axiale Wand 30 isolierend ausgebildet werden, um die entgegen der z-Richtung verlaufenden, äußeren Fluidströme abzukoppeln. Dann wird der Gegenstrom GS im Strömungskanal 31 vom Gegenstrom im Strömungskanal 51 thermisch abgekoppelt, d.h. der Gegenstrom (im Strömungskanal 31) wird gegenüber dem Gegenstrom in einem stromaufwärts liegenden Abschnitt (im Strömungskanal 51) isoliert. Falls abweichend von Fig. 6 der Fluideinlass 32 für den Gegenstrombereich GB am oberen axialen Endbereich 23 ausgebildet wäre, sollte die Wand 53 isolierend ausgebildet werden, um den entgegen der z-Richtung fließenden Mantelstrom MS abzukopppeln, nicht aber den äußersten Teil des in z-Richtung fließenden Gegenstroms GS.

Zusammenfassend beschreibt die vorliegende Erfindung die Temperierung (Kühlung oder Beheizung) eines NMR-Probenröhrchens, wobei durch einen Fluidstrom nach dem Gegenstromprinzip unmittelbar am Probenröhrchen ein geringer Temperaturgradient eingerichtet wird. Zur Unterstützung der Temperierungsleistung wird zusätzlich ein weiterer Fluidstrom eingesetzt, der den Bereich des Gegenstroms und des aktiven Volumens des NMR-Probenröhrchens vortemperiert. Der weitere Fluidstrom wirkt dabei von außen auf den Bereich des Gegenstroms und des aktiven Volumens des NMR-Probenröhrchens ein ("Mantelstrom"). Der Mantelstrom wird im Gegensatz zum Gegenstrom nicht durch Umlenkungen und das Passieren eines engen Spalts an der Außenseite des NMR-Probenröhrchens begrenzt und kann daher mit hohen Flussraten - und somit hohen Temperierleistungen - eingerichtet werden.

## Patentansprüche

1. Temperiereinrichtung (20) für ein NMR-Probenröhrchen (22),
wobei um einen zylindrischen Innenraum (21) zur Aufnahme des NMR-Probenröhrchens (22) mehrere ineinander geschachtelte, konzentrische, zum Innenraum (21) koaxial verlaufende Strömungskanäle (28, 31; 40, 41, 42; 50, 51) für temperierendes Fluid ausgebildet sind,
wobei die Temperiereinrichtung (20) in einem axialen Endbereich (26) geschlossen zum Innenraum (21) und in einem gegenüberliegenden axialen Endbereich (23) für das Einführen des NMR-Probenröhrchens (22) in den Innenraum (21) offen zum Innenraum (21) ausgebildet ist, wobei in einem Gegenstrombereich (GB) benachbarte Strömungskanäle (28, 31; 40, 41, 42; 51) jeweils mit einem Fluiddurchlass (34, 43, 44) an einem axialen Ende so miteinander verbunden sind, dass sich die Strömungsrichtung eines Fluidstroms in den Strömungskanälen (28, 31; 40, 41, 42; 51) des Gegenstrombereichs (GB) zum jeweils benachbarten Strömungskanal (28, 31; 40, 41, 42; 51) im Gegenstrombereich (GB) umkehrt,
wobei der äußerste Strömungskanal (28; 51) des Gegenstrombereichs (GB) an einem axialen Ende einen Fluideinlass (32) aufweist,
wobei der innerste Strömungskanal (31; 42) des Gegenstrombereichs (GB) an einem axialen Ende, welches dem geschlossen ausgebildeten axialen Endbereich (26) zugewandt ist, einen Fluiddurchlass (36) zum Innenraum (21) aufweist,
und wobei die Temperiereinrichtung (20) weiterhin das NMR-Probenröhrchen (22) umfasst, das im Innenraum (21) angeordnet ist,
**dadurch gekennzeichnet,**
**dass** mindestens einer der Strömungskanäle (28, 31; 40, 41, 42; 50, 51), nämlich der äußerste Strömungskanal (28; 50) der Temperiereinrichtung (20) und/oder der nächst innere Strömungskanal (31; 40; 51) der Temperiereinrichtung (20), an einem axialen Ende einen Fluidauslass (35) aufweist, durch welchen zumindest ein Teil (MS) eines im äußersten Strömungskanal (28; 50) der Temperiereinrichtung (20) geführten temperierenden Fluidstroms aus der Temperiereinrichtung (20) entweichen kann, ohne alle Strömungskanäle (28, 31; 40, 41, 42; 51) des Gegenstrombereichs (GB) vollständig zu passieren,
und **dass** die Temperiereinrichtung (20) so ausgebildet ist, dass von einem gesamten, der Temperiereinrichtung (20) zufließenden temperierenden Fluidstrom wenigstens 50% durch den Fluidauslass (35) am axialen Ende des äußersten Strömungskanals (28; 50) oder des nächst inneren Strömungskanals (31; 40; 51) entweichen kann.

2. Temperiereinrichtung (20) nach Anspruch 1, **dadurch gekennzeichnet, dass** der äußerste Strömungskanal (28; 51) des Gegenstrombereichs (GB) und/oder der nächst innere Strömungskanal (31; 40) des Gegenstrombereichs (GB) an dem axialen Ende, welches dem Fluideinlass (32) abgewandt ist, den Fluidauslass (35) aufweist, insbesondere wobei alle Strömungskanäle (28, 31; 40, 41, 42; 50; 51) der Temperiereinrichtung (20) zum Gegenstrombereich (GB) gehören.

3. Temperiereinrichtung (20) nach Anspruch 2, **dadurch gekennzeichnet, dass** der äußerste Strömungskanal (28; 51) des Gegenstrombereichs (GB) eine äußere Abteilung (28a) und eine innere Abteilung (28b) umfasst, die von einer axialen Zwischenwand (28c) getrennt sind, wobei die axiale Zwischenwand (28c) sich über einen Teil der axialen Länge des äußersten Strömungskanals (28; 51) des Gegenstrombereichs (GB) erstreckt, wobei dieser Teil der axialen Länge sich von einem axialen Ende des äußersten Strömungskanals (28; 51) des Gegenstrombereichs (GB), welches den Fluidauslass (35) aufweist, weg erstreckt,
und dass die äußere Abteilung (28a) den Fluidauslass (35) aufweist, und die innere Abteilung (28b) den Fluiddurchlass (34) zum nächst inneren Strömungskanal (31, 40) aufweist.

4. Temperiervorrichtung (20) nach Anspruch 1, **dadurch gekennzeichnet, dass** ein zusätzlicher Strömungskanal (50) ausgebildet ist, welcher den äußersten Strömungskanal (28; 51) des Gegenstrombereichs (GB) umschließt,
und dass der zusätzliche Strömungskanal (50) an einem axialen Ende einen zusätzlichen Fluideinlass (52) und an einem gegenüberliegenden axialen Ende den Fluidauslass (35) aufweist.

5. Temperiereinrichtung (20) nach Anspruch 4, **dadurch gekennzeichnet, dass** der Fluideinlass (32) und der zusätzliche Fluideinlass (52) am selben axialen Endbereich (23, 26) der Temperiereinrichtung (20) ausgebildet sind und an einen gemeinsamen Zulauf (33) eines temperierenden Fluidstroms angeschlossen sind.

6. Temperiereinrichtung (20) nach einem der vorhergehenden Ansprüche, **dadurch gekennzeichnet, dass** eine axiale Wand (30, 53), welche den äußersten Strömungskanal (28; 51) des Gegenstrombereichs (GB) oder den zusätzlichen Strömungskanal (50) vom nächst inneren Strömungskanal (31; 40; 51) abtrennt, in transversaler Richtung einen Wärmedurchgangskoeffizienten U_{AN} aufweist,
und dass alle etwaigen übrigen axialen Wände (45, 46), welche zwischen Strömungskanälen (28, 31; 40, 41, 42; 51) des Gegenstrombereichs (GB) liegen, und eine axiale Wand (39), die den innersten Strömungskanal (31; 42) vom Innenraum (21) abgrenzt, in transversaler Richtung jeweils einen Wärmedurchgangskoeffizienten größer als U_{AN}, bevorzugt größer als 3*U_{AN}, ganz besonders bevorzugt größer als 10*U_{AN}, und weiter bevorzugt größer als 50*U_{AN}, aufweisen.

7. Temperiereinrichtung (20) nach einem der vorhergehenden Ansprüche, **dadurch gekennzeichnet, dass** der Fluidauslass (35) an einem axialen Ende des äußersten Strömungskanals (28; 50) der Temperiereinrichtung (20) und/oder des nächst inneren Strömungskanals (31; 40; 51) der Temperiereinrichtung (20) ausgebildet ist, welches dem offenen ausgebildeten axialen Endbereich (23) zugewandt ist.

8. Temperiereinrichtung (20) nach einem der vorhergehenden Ansprüche, **dadurch gekennzeichnet, dass** der Innenraum (21) kreiszylindrisch ausgebildet ist, und dass die Strömungskanäle (28, 31; 40, 41, 42; 50, 51) im Querschnitt kreisringförmig ausgebildet sind.

9. Temperiereinrichtung (20) nach einem der vorhergehenden Ansprüche, **dadurch gekennzeichnet, dass** der Fluideinlass (32) und/oder der zusätzliche Fluideinlass (52) und/oder der Fluidauslass (35) und/oder mindestens einer der Fluiddurchlässe (34, 36; 43, 44) durch mehrere, symmetrisch um eine Mittelachse (MA) des Innenraums (21) verteilte Öffnungen (32a-32d) ausgebildet ist.

10. Temperiereinrichtung (20) nach einem der vorhergehenden Ansprüche, **dadurch gekennzeichnet, dass** der Fluideinlass (32) und/oder der zusätzliche Fluideinlass (52) und/oder der Fluidauslass (35) und/oder mindestens einer der Fluiddurchlässe (34, 36; 43, 44) durch einen ringförmigen Spalt ausgebildet ist.

11. Temperiereinrichtung (20) nach einem der vorhergehenden Ansprüche, **dadurch gekennzeichnet, dass** der Gegenstrombereich (GB) genau zwei ineinander geschachtelte Strömungskanäle (28, 31) umfasst.

12. Temperiereinrichtung (20) nach einem der vorhergehenden Ansprüche, **dadurch gekennzeichnet, dass** die Anzahl der ineinander geschachtelten Strömungskanäle (28, 31; 40, 41, 42; 51) des Gegenstrombereichs (GB) gerade ist.

13. Temperiereinrichtung (20) nach einem der vorhergehenden Ansprüche, **dadurch gekennzeichnet, dass** mindestens ein Strömungskanal (28, 31; 40, 41, 42; 50, 51) eine HF-Spule (37, 38) enthält,
insbesondere wobei die HF-Spule (37, 38) an der inneren Wand (39, 30) eines Strömungskanals (28, 31; 40, 41, 42; 50, 51) aufsitzt.

14. Verfahren zur Temperierung eines NMR-Probenröhrchens (22),
wobei ein temperierender Fluidstrom nach dem Gegenstromprinzip (GS) in ineinander geschachtelten Strömungskanälen (28, 31; 40, 41, 42; 51) alternierend entlang einer axialen Erstreckungsrichtung (z) des NMR-Probenröhrchens (22) und dazu entgegengesetzt geführt wird, **dadurch gekennzeichnet,**
**dass** zusätzlich zum Fluidstrom nach dem Gegenstromprinzip (GS) ein temperierender Fluidstrom nach dem Mantelstromprinzip (MS) eingesetzt wird, wobei der Fluidstrom nach dem Mantelstromprinzip (MS) zumindest einen Teil des Bereichs, in welchem der Fluidstrom nach dem Gegenstromprinzip (GS) geführt wird, und zumindest einen Teil des NMR-Probenröhrchens (22) umschließt,
und **dass** der Fluidstrom nach dem Mantelstromprinzip (MS) wenigstens 50% eines temperierenden Gesamtfluidstroms (GFS), definiert durch die Summe des Fluidstroms nach dem Mantelstromprinzip (MS) und des Fluidstroms nach dem Gegenstromprinzip (GS), beträgt.

15. Verfahren nach Anspruch 14, **dadurch gekennzeichnet, dass** der Fluidstrom nach dem Mantelstromprinzip (MS) lediglich einmal entlang der Erstreckungsrichtung (z) des NMR-Probenröhrchens (22) geführt wird.

16. Verfahren nach Anspruch 14 oder 15, **dadurch gekennzeichnet, dass** der erste Teil (MS) des temperierenden Gesamtfluidstroms, der durch den temperierenden Fluidstrom nach dem Mantelstromprinzip gebildet wird, und der zweite Teil (GS) des temperierenden Gesamtfluidstroms, der durch den temperierenden Fluidstrom nach dem Gegenstromprinzip gebildet wird, zunächst gemeinsam fließen, insbesondere in einem äußersten Strömungskanal (28) einer Temperiereinrichtung (20), und danach aufgetrennt werden.

17. Verfahren nach Anspruch 16, **dadurch gekennzeichnet, dass** der aufgetrennte zweite Teil (GS)
- vom aufgetrennten ersten Teil (MS)
- oder vom gemeinsam fließenden Gesamtfluidstrom (GFS)
- oder vom aufgetrennten zweiten Teil (GS) in einem stromaufwärts liegenden Abschnitt
thermisch isoliert wird.

18. Verfahren nach Anspruch 14 oder 15, **dadurch gekennzeichnet, dass** der Fluidstrom nach dem Gegenstromprinzip (GS) und der Fluidstrom nach dem Mantelstromprinzip (MS) vollständig separat geführt werden, und insbesondere separat geregelt und temperiert werden.

19. Verfahren nach Anspruch 18, **dadurch gekennzeichnet, dass** der Fluidstrom nach dem Gegenstromprinzip (GS)
- vom Fluidstrom nach dem Mantelstromprinzip (MS)
- oder vom Fluidstrom nach dem Gegenstromprinzip (GS) in einem stromaufwärts liegenden Abschnitt
thermisch isoliert wird.

20. Verwendung einer Temperiereinrichtung (20) nach einem der Ansprüche 1 bis 13, insbesondere in einem Verfahren nach einem der Ansprüche 14 bis 19,
zur Temperierung des NMR-Probenröhrchens (22), welches im Innenraum (21) der Temperiereinrichtung (20) angeordnet ist.

21. Verwendung nach Anspruch 20, **dadurch gekennzeichnet, dass** als Fluid ein Gas, insbesondere Luft oder Stickstoff, verwendet wird.

22. Verwendung nach Anspruch 20 oder 21, wobei sich im Fluidstrom an der Außenseite des NMR-Probenröhrchens (22) ein Temperaturgradient einstellt, welcher umgekehrt zum Temperaturgradienten im Fluidstrom im äußersten Strömungskanal (28; 50) der Temperiereinrichtung (20) verläuft.

## Claims

1. Temperature control device (20) for an NMR sample tube (22),
wherein multiple interleaved, concentric flow channels (28, 31; 40, 41, 42; 50, 51) for temperature control fluid extending coaxially with respect to a cylindrical interior space (21) for holding the NMR sample tube (22) are constituted around said interior space (21), wherein said temperature control device (20) is constituted such that it is closed toward the interior space (21) in an axial end region (26) and, in an axial end region (23) at the opposite end thereto, open to the interior space (21) for inserting the NMR sample tube (22) into said interior space (21),
wherein, in a counter flow region (GB), adjacent flow channels (28, 31; 40, 41, 42; 51) are interconnected through a fluid passage (34, 43, 44) at one axial end in such a way that the direction of flow of a fluid flow in the flow channels (28, 31; 40, 41, 42; 51) of the counter flow region (GB) is reversed with respect to the corresponding adjacent flow channel (28, 31; 40, 41, 42; 51) in the counter flow region (GB),
wherein the outermost flow channel (28; 51) of the counter flow region (GB) has a fluid inlet (32) at one axial end, wherein the innermost flow channel (31; 42) of the counter flow region (GB) has a fluid passage (36) to the interior space (21) at one axial end that faces toward the axial end region (26) that is closed, and wherein the temperature control device (20) moreover comprises the NMR sample tube (22) that is arranged in the interior space (21), at least one of the flow channels (28, 31; 40, 41, 42; 50, 51), namely the outermost flow channel (28; 50) of the temperature control device (20) and/or the next outermost flow channel (31; 40; 51) of the temperature control device (20) has a fluid outlet (35) at one axial end, through which at least part (MS) of a temperature-controlling fluid flow that is conveyed along the outermost flow channel (28; 50) of the temperature control device (20) can escape from the temperature control device (20) without passing completely through all of the flow channels (28, 31; 40, 41, 42; 51) of the counter flow region (GB), and that the temperature control device (20) is constituted such that of a total temperature-controlling fluid flow that flows to the temperature control device (20), at least 50% can escape through the fluid outlet (35) at the axial end of the outermost flow channel (28; 50) or the next outermost flow channel (31; 40; 51).

2. Temperature control device (20) according to claim 1, **characterized in that** the outermost flow channel (28; 51) of the counter flow region (GB) and/or the next outermost flow channel (31; 40) of the counter flow region (GB) has the fluid outlet (35) at the axial end that faces away from the fluid inlet (32), in particular wherein all flow channels (28, 31; 40, 41, 42; 50; 51) of the temperature control device (20) are part of the counter flow region (GB).

3. Temperature control device (20) according to claim 2, **characterized in that** the outermost flow channel (28; 51) of the counter flow region (GB) comprises an outer compartment (28a) and an inner compartment (28b), which are separated by an axial intermediate wall (28c), wherein the axial intermediate wall (28c) extends along a section of the axial length of the outermost flow channel (28; 51) of the counter flow region (GB), wherein this section of the axial length extends away from one axial end of the outermost flow channel (28; 51) of the counter flow region (GB) that has the fluid outlet (35), and the outer compartment (28a) has the fluid outlet (35), and the inner compartment (28b) has the fluid passage (34) to the next outermost flow channel (31, 40).

4. Temperature control device (20) according to claim 1, **characterized in that** an additional flow channel (50) is constituted that surrounds the outermost flow channel (28; 51) of the counter flow region (GB), and that the additional flow channel (50) has an additional fluid inlet (52) at one axial end and the fluid outlet (35) at an opposite axial end.

5. Temperature control device (20) according to claim 4, **characterized in that** the fluid inlet (32) and the additional fluid inlet (52) are constituted at the same axial end region (23, 26) of the temperature control device (20) and are connected to a joint supply (33) of a temperature-controlling fluid flow.

6. Temperature control device (20) according to any one of the previous claims, **characterized in that** an axial wall (30, 53), that separates the outermost flow channel (28; 51) of the counter flow region (GB) or the additional flow channel (50) from the next outermost flow channel (31; 40; 51), exhibits a thermal transmittance U_{AN} in the transverse direction,
and that any other remaining axial walls (45, 46) that are located between the flow channels (28, 31; 40, 41, 42; 51) of the counter flow region (GB) and an axial wall (39) that separates the innermost flow channel (31; 42) from the interior space (21), each exhibit a thermal transmittance in the transverse direction greater than U_{AN}, preferably greater than 3*U_{AN}, highly preferably greater than 10*U_{AN} and further preferably greater than 50*U_{AN}.

7. Temperature control device (20) according to any one of the previous claims, **characterized in that** the fluid outlet (35) is constituted at one axial end of the outermost flow channel (28; 50) of the temperature control device (20) and/or of the next outermost flow channel (31; 40; 51) of the temperature control device (20) that faces the open axial end region (23).

8. Temperature control device (20) according to any one of the previous claims, **characterized in that** the interior space (21) is constituted as a circular cylinder and that the flow channels (28, 31; 40, 41, 42; 50; 51) are circular ring-shaped in cross-section.

9. Temperature control device (20) according to any one of the previous claims, **characterized in that** the fluid inlet (32) and/or the additional fluid inlet (52) and/or the fluid outlet (35) and/or at least one of the fluid passages (34, 36; 43, 44) is/are constituted by multiple openings (32a-32d) distributed symmetrically around a center axis (MA) of the interior space (21).

10. Temperature control device (20) according to any one of the previous claims, **characterized in that** the fluid inlet (32) and/or the additional fluid inlet (52) and/or the fluid outlet (35) and/or at least one of the fluid passages (34, 36; 43, 44) is/are constituted by.a ring-shaped gap.

11. Temperature control device (20) according to any one of the previous claims, **characterized in that** the counter flow region (GB) comprises exactly two interleaved flow channels (28, 31).

12. Temperature control device (20) according to any one of the previous claims, **characterized in that** the number of interleaved flow channels (28, 31; 40, 41, 42; 51) of the counter flow region (GB) is even.

13. Temperature control device (20) according to any one of the previous claims, **characterized in that** at least one flow channel (28, 31; 40, 41, 42; 50, 51) contains an RF coil (37, 38),
in particular wherein the RF coil (37, 38) is seated against the inner wall (39, 30) of a flow channel (28, 31; 40, 41, 42; 50, 51).

14. Method for controlling the temperature of an NMR sample tube (22), wherein a temperature-controlling fluid flow is conveyed according to the counter flow principle (GS) in interleaved flow channels (28, 31; 40, 41, 42; 51) alternately along a direction of axial extension (z) of the NMR sample tube (22) and in the reverse direction,
**characterized in that**
in addition to the fluid flow according to the counter flow principle (GS), a temperature-controlling fluid flow according to the sheath flow principle (MS) is used, wherein the fluid flow according to the sheath flow principle (MS) encompasses at least part of the region in which the fluid flow is conveyed according to the counter flow principle (GS) and at least part of the NMR sample tube (22), and that the fluid flow according to the sheath flow principle (MS) amounts to at least 50% of a temperature-controlling total fluid flow (GFS) defined by the sum of the fluid flow according to the sheath flow principle (MS) and the fluid flow according to the counter flow principle (GS).

15. Method according to claim 14, **characterized in that** the fluid flow according to the sheath flow principle (MS) is conveyed only once along the direction of extension (z) of the NMR sample tube (22).

16. Method according to claim 14 or 15, **characterized in that** the first part (MS) of the temperature-controlling total fluid flow constituted by the temperature-controlling fluid flow according to the sheath flow principle and the second part (GS) of the temperature-controlling total fluid flow constituted by the temperature-controlling fluid flow according to the counter flow principle, initially flow together, in particular in an outermost flow channel (28) of a temperature control device (20), and are separated thereafter.

17. Method according to claim 16, **characterized in that** the separated second part (GS) is thermally insulated
- from the separated first part (MS)
- or from the jointly flowing total fluid flow (GFS)
- or from the separated second part (GS) in an upstream section.

18. Method according to claim 14 or 15, **characterized in that** the fluid flow according to the counter flow principle (GS) and the fluid flow according to the sheath flow principle (MS) are conveyed completely separately and, in particular, separately regulated and temperature-controlled.

19. Method according to claim 18, **characterized in that** the fluid flow according to the counter flow principle (GS) is thermally insulated
- from the fluid flow according to the sheath flow principle (MS)
- or from the fluid flow according to the counter flow principle (GS) in an upstream section.

20. Use of a temperature control device (20) according to any one of the claims 1 to 13, in particular in a method according to any one of the claims 14 to 19,
for the temperature control of the NMR sample tube (22), which is disposed in the interior space (21) of the temperature control device (20).

21. Use according to claim 20, **characterized in that** a gas, in particular air or nitrogen, is used as the fluid.

22. Use according to claim 20 or 21, wherein a temperature gradient is established in the fluid flow on the outer surface of the NMR sample tube (22), which is inverted with respect to the temperature gradient in the fluid flow in the outermost flow channel (28; 50) of the temperature control device (20).

## Revendications

1. Dispositif de thermorégulation (20) pour un tube à échantillon de RMN (22), dans lequel sont formés plusieurs canaux d'écoulement concentriques imbriqués (28, 31 ; 40, 41, 42 ; 50, 51) pour un fluide thermorégulant, qui s'étendent autour d'un espace intérieur cylindrique (21) destiné à recevoir le tube à échantillon de RMN (22), coaxialement à l'espace intérieur (21),
le dispositif de thermorégulation (20) étant conçu fermé vers l'espace intérieur (21) dans une zone d'extrémité axiale (26) et ouvert vers l'espace intérieur (21) dans une zone d'extrémité axiale opposée (23) pour l'introduction du tube à échantillon de RMN (22) dans l'espace intérieur (21),
dans lequel, dans une zone à contre-courant (GB), des canaux d'écoulement adjacents (28, 31 ; 40, 41, 42 ; 51) sont chaque fois reliés les uns aux autres par un passage de fluide (34, 43, 44) à une extrémité axiale de telle sorte que la direction d'écoulement d'un courant de fluide dans les canaux d'écoulement (28, 31 ; 40, 41, 42 ; 51) de la zone à contre-courant (GB) s'inverse par rapport au canal d'écoulement respectivement adjacent (28, 31 ; 40, 41, 42 ; 51) dans la zone à contre-courant (GB), dans lequel le canal d'écoulement le plus extérieur (28 ; 51) de la zone à contre-courant (GB) présente une entrée de fluide (32) à une extrémité axiale,
dans lequel le canal d'écoulement le plus intérieur (31 ; 42) de la zone à contre-courant (GB) présente un passage de fluide (36) vers l'espace intérieur (21) à une extrémité axiale qui est tournée vers la zone d'extrémité axiale fermée (26),
et dans lequel le dispositif de thermorégulation (20) comprend en outre le tube à échantillon de RMN (22) qui est disposé dans l'espace intérieur (21),
**caractérisé en ce**
**qu'**au moins l'un des canaux d'écoulement (28, 31 ; 40, 41, 42 ; 50, 51), à savoir le canal d'écoulement le plus extérieur (28 ; 50) du dispositif de thermorégulation (20) et/ou le canal d'écoulement intérieur suivant (31 ; 40 ; 51) du dispositif de thermorégulation (20), présente, à une extrémité axiale, une sortie de fluide (35) par laquelle au moins une partie (MS) d'un courant de fluide thermorégulant guidé dans le canal d'écoulement le plus extérieur (28 ; 50) du dispositif de thermorégulation (20) peut s'échapper du dispositif de thermorégulation (20) sans passer entièrement par tous les canaux d'écoulement (28, 31 ; 40, 41, 42 ; 51) de la zone à contre-courant (GB),
et **que** le dispositif de thermorégulation (20) est conçu de telle sorte qu'au moins 50 % d'un courant total de fluide thermorégulant s'écoulant vers le dispositif de thermorégulation (20) peut s'échapper par la sortie de fluide (35) à l'extrémité axiale du canal d'écoulement le plus extérieur (28 ; 50) ou du canal d'écoulement intérieur suivant (31 ; 40 ; 51).

2. Dispositif de thermorégulation (20) selon la revendication 1, **caractérisé en ce que** le canal d'écoulement le plus extérieur (28 ; 51) de la zone à contre-courant (GB) et/ou le canal d'écoulement intérieur suivant (31 ; 40) de la zone à contre-courant (GB) présente la sortie de fluide (35) à l'extrémité axiale opposée à l'entrée de fluide (32), en particulier tous les canaux d'écoulement (28, 31 ; 40, 41, 42 ; 50 ; 51) du dispositif de thermorégulation (20) appartenant à la zone à contre-courant (GB).

3. Dispositif de thermorégulation (20) selon la revendication 2, **caractérisé en ce que** le canal d'écoulement le plus extérieur (28 ; 51) de la zone à contre-courant (GB) comprend une section extérieure (28a) et une section intérieure (28b) qui sont séparées par une paroi intermédiaire axiale (28c), la paroi intermédiaire axiale (28c) s'étendant sur une partie de la longueur axiale du canal d'écoulement le plus extérieur (28 ; 51) de la zone à contre-courant (GB), cette partie de la longueur axiale s'étendant en s'éloignant d'une extrémité axiale du canal d'écoulement le plus extérieur (28 ; 51) de la zone à contre-courant (GB) qui présente la sortie de fluide (35),
et que la section extérieure (28a) présente la sortie de fluide (35) et la section intérieure (28b) présente le passage de fluide (34) vers le canal d'écoulement intérieur suivant (31, 40).

4. Dispositif de thermorégulation (20) selon la revendication 1, **caractérisé en ce qu'**un canal d'écoulement supplémentaire (50) est formé, lequel entoure le canal d'écoulement le plus extérieur (28 ; 51) de la zone à contre-courant (GB),
et que le canal d'écoulement supplémentaire (50) présente une entrée de fluide supplémentaire (52) à une extrémité axiale et la sortie de fluide (35) à une extrémité axiale opposée.

5. Dispositif de thermorégulation (20) selon la revendication 4, **caractérisé en ce que** l'entrée de fluide (32) et l'entrée de fluide supplémentaire (52) sont formées dans la même zone d'extrémité axiale (23, 26) du dispositif de thermorégulation (20) et sont raccordées à une arrivée commune (33) d'un courant de fluide thermorégulant.

6. Dispositif de thermorégulation (20) selon l'une des revendications précédentes, **caractérisé en ce qu'**une paroi axiale (30, 53) qui sépare le canal d'écoulement le plus extérieur (28 ; 51) de la zone à contre-courant (GB) ou le canal d'écoulement supplémentaire (50) du canal d'écoulement intérieur suivant (31 ; 40 ; 51) présente, dans la direction transversale, un coefficient de transmission thermique U_{AN},
et que toutes les éventuelles parois axiales restantes (45, 46) qui se trouvent entre des canaux d'écoulement (28, 31 ; 40, 41, 42 ; 51) de la zone à contre-courant (GB) et une paroi axiale (39) qui délimite le canal d'écoulement le plus intérieur (31 ; 42) de l'espace intérieur (21) présentent, dans la direction transversale, un coefficient de transmission thermique respectif supérieur à U_{AN}, de préférence supérieur à 3^{∗}U_{AN}, tout particulièrement de préférence supérieur à 10^{∗}U_{AN} et encore davantage de préférence supérieur à 50^{∗}U_{AN}.

7. Dispositif de thermorégulation (20) selon l'une des revendications précédentes, **caractérisé en ce que** la sortie de fluide (35) est formée à une extrémité axiale du canal d'écoulement le plus extérieur (28 ; 50) du dispositif de thermorégulation (20) et/ou du canal d'écoulement intérieur suivant (31 ; 40 ; 51) du dispositif de thermorégulation (20) qui est tournée vers la zone d'extrémité axiale ouverte (23).

8. Dispositif de thermorégulation (20) selon l'une des revendications précédentes, **caractérisé en ce que** l'espace intérieur (21) est de forme cylindrique circulaire, et que les canaux d'écoulement (28, 31 ; 40, 41, 42 ; 50, 51) sont de forme annulaire circulaire en section transversale.

9. Dispositif de thermorégulation (20) selon l'une des revendications précédentes, **caractérisé en ce que** l'entrée de fluide (32) et/ou l'entrée de fluide supplémentaire (52) et/ou la sortie de fluide (35) et/ou au moins l'un des passages de fluide (34, 36 ; 43, 44) est formé(e) par plusieurs ouvertures (32a-32d) réparties de manière symétrique autour d'un axe médian (MA) de l'espace intérieur (21).

10. Dispositif de thermorégulation (20) selon l'une des revendications précédentes, **caractérisé en ce que** l'entrée de fluide (32) et/ou l'entrée de fluide supplémentaire (52) et/ou la sortie de fluide (35) et/ou au moins l'un des passages de fluide (34, 36 ; 43, 44) est formé(e) par une fente annulaire.

11. Dispositif de thermorégulation (20) selon l'une des revendications précédentes, **caractérisé en ce que** la zone à contre-courant (GB) comprend exactement deux canaux d'écoulement imbriqués (28, 31).

12. Dispositif de thermorégulation (20) selon l'une des revendications précédentes, **caractérisé en ce que** le nombre de canaux d'écoulement imbriqués (28, 31 ; 40, 41, 42 ; 51) de la zone à contre-courant (GB) est pair.

13. Dispositif de thermorégulation (20) selon l'une des revendications précédentes, **caractérisé en ce qu'**au moins un canal d'écoulement (28, 31 ; 40, 41, 42 ; 50, 51) contient une bobine HF (37, 38),
en particulier la bobine HF (37, 38) reposant sur la paroi intérieure (39, 30) d'un canal d'écoulement (28, 31 ; 40, 41, 42 ; 50, 51).

14. Procédé de thermorégulation d'un tube à échantillon de RMN (22),
dans lequel un courant de fluide thermorégulant est guidé selon le principe du contre-courant (GS) dans des canaux d'écoulement imbriqués (28, 31 ; 40, 41, 42; 51) alternativement dans une direction d'extension axiale (z) du tube à échantillon de RMN (22) et dans une direction opposée à celle-ci,
**caractérisé en ce**
**que**, en plus du courant de fluide selon le principe du contre-courant (GS), on utilise un courant de fluide thermorégulant selon le principe du courant de dérivation (MS), le courant de fluide selon le principe du courant de dérivation (MS) entourant au moins une partie de la zone dans laquelle le courant de fluide est guidé selon le principe du contre-courant (GS) et au moins une partie du tube à échantillon de RMN (22),
et **que** le courant de fluide selon le principe du courant de dérivation (MS) représente au moins 50 % d'un courant de fluide thermorégulant total (GFS), défini par la somme du courant de fluide selon le principe du courant de dérivation (MS) et du courant de fluide selon le principe du contre-courant (GS).

15. Procédé selon la revendication 14, **caractérisé en ce que** le courant de fluide selon le principe du courant de dérivation (MS) n'est guidé qu'une seule fois dans la direction d'extension (z) du tube à échantillon de RMN (22).

16. Procédé selon la revendication 14 ou 15, **caractérisé en ce que** la première partie (MS) du courant de fluide thermorégulant total, qui est formée par le courant de fluide thermorégulant selon le principe du courant de dérivation, et la deuxième partie (GS) du courant de fluide thermorégulant total, qui est formée par le courant de fluide thermorégulant selon le principe du contre-courant, s'écoulent d'abord ensemble, en particulier dans un canal d'écoulement le plus extérieur (28) d'un dispositif de thermorégulation (20), puis sont séparées.

17. Procédé selon la revendication 16, **caractérisé en ce que** la deuxième partie séparée (GS) est isolée thermiquement
- de la première partie séparée (MS),
- du courant total de fluide (GFS) s'écoulant ensemble
- ou de la deuxième partie séparée (GS) dans une partie située en amont.

18. Procédé selon la revendication 14 ou 15, **caractérisé en ce que** le courant de fluide selon le principe du contre-courant (GS) et le courant de fluide selon le principe du courant de dérivation (MS) sont guidé entièrement séparément, et en particulier réglés et thermorégulés séparément.

19. Procédé selon la revendication 18, **caractérisé en ce que** le courant de fluide selon le principe du contre-courant (GS) est isolé thermiquement
- du courant de fluide selon le principe du courant de dérivation (MS)
- ou du courant de fluide selon le principe du contre-courant (GS) dans une partie située en amont.

20. Utilisation d'un dispositif de thermorégulation (20) selon l'une des revendications 1 à 13, en particulier dans un procédé selon l'une des revendications 14 à 19, pour la thermorégulation du tube à échantillon de RMN (22) qui est disposé dans l'espace intérieur (21) du dispositif de thermorégulation (20).

21. Utilisation selon la revendication 20, **caractérisée en ce qu'**un gaz, en particulier de l'air ou de l'azote, est utilisé comme fluide.

22. Utilisation selon la revendication 20 ou 21, dans laquelle un gradient de température s'établit dans le courant de fluide sur le côté extérieur du tube à échantillon de RMN (22), lequel gradient de température varie en sens inverse du gradient de température du courant de fluide dans le canal d'écoulement le plus extérieur (28 ; 50) du dispositif de thermorégulation (20).
